(19) **Europäisches Patentamt / European Patent Office / Office européen des brevets**

(11) **EP 4 528 575 B1**

(12) **EUROPEAN PATENT SPECIFICATION**

(45) Date of publication and mention
of the grant of the patent:
**04.03.2026 Bulletin 2026/10**

(21) Application number: **23934300.7**

(22) Date of filing: **31.10.2023**

(51) International Patent Classification (IPC):
***G06F 30/398*** (2020.01)    ***G03F 1/70*** (2012.01)
***G03F 1/36*** (2012.01)

(52) Cooperative Patent Classification (CPC):
**G03F 1/70; G03F 1/36; Y02P 90/30**

(86) International application number:
**PCT/CN2023/128552**

(87) International publication number:
**WO 2025/030684 (13.02.2025 Gazette 2025/07)**

(54) **MASK GENERATION MODEL TRAINING METHOD AND APPARATUS, MASK GENERATION METHOD AND APPARATUS, AND STORAGE MEDIUM**

VERFAHREN UND VORRICHTUNG ZUM TRAINIEREN EINES MASKENERZEUGUNGSMODELLS, VERFAHREN UND VORRICHTUNG ZUR MASKENERZEUGUNG UND SPEICHERMEDIUM

PROCÉDÉ ET APPAREIL D'ENTRAÎNEMENT DE MODÈLE DE GÉNÉRATION DE MASQUE, PROCÉDÉ ET APPAREIL DE GÉNÉRATION DE MASQUE ET SUPPORT DE STOCKAGE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **10.08.2023  CN 202311005424**

(43) Date of publication of application:
**26.03.2025  Bulletin 2025/13**

(73) Proprietor: **TENCENT TECHNOLOGY (SHENZHEN) COMPANY LIMITED**
**Shenzhen, Guangdong 518057 (CN)**

(72) Inventors:
• **MA, Xingyu**
**Shenzhen**
**Guangdong 518057 (CN)**

• **HAO, Shaogang**
**Shenzhen**
**Guangdong 518057 (CN)**
• **ZHANG, Shengyu**
**Shenzhen**
**Guangdong 518057 (CN)**

(74) Representative: **Gunzelmann, Rainer**
**Wuesthoff & Wuesthoff**
**Patentanwälte und Rechtsanwalt PartG mbB**
**Schweigerstraße 2**
**81541 München (DE)**

(56) References cited:
WO-A1-2020/002143        CN-A- 115 222 829
CN-A- 115 222 829        CN-A- 116 342 983
CN-A- 116 342 983        CN-A- 116 720 479
US-A1- 2009 068 772        US-A1- 2019 101 834
US-A1- 2021 072 635

**Description**

FIELD OF THE TECHNOLOGY

Embodiments of the present disclosure relate to the field of artificial intelligence (AI) technologies, and in particular, to a method for training a mask generation model, a method and an apparatus for mask generation, and a storage medium.

BACKGROUND OF THE DISCLOSURE

A photolithography process is referred to as a process to transfer a geometric figure on a mask to a photoresist on a surface of a wafer. A photoresist processing device is used to spin coating the photoresist on the surface of the wafer. After step-and-repeat exposure and development processing, a required pattern is formed on the wafer. As a feature size of a very large-scale integrated circuit continues to shorten and is below a light source wavelength used in the photolithography process, an interference phenomenon and a diffraction phenomenon are clearly apparent. As a result, a pattern formed by exposure on a wafer through a mask differs greatly from a required pattern, which seriously affects chip performance, throughput, and yield. To resolve this problem, deep learning technologies are applied to various fields of chip design and manufacturing. To ensure high quality of the mask, low complexity of a generated mask needs to be ensured.

In the related art, one method is to optimize the generated mask by using a deep learning algorithm, and another method is to generate the mask by using a pixelation-based inverse lithography technology. However, masks generated by the two methods have high complexity and are difficult to be used in large-scale integrated circuit layout optimization. Related methods are for instance described in CN 116 342 983 and in CN 115 222 829.

SUMMARY

Embodiments of the present disclosure provide a method for training a mask generation model, a method and an apparatus for mask generation, and a storage medium, which can reduce complexity of a mask.

According to a first aspect, an embodiment of the present disclosure provides a method for training a mask generation model, including:

obtaining a set of training samples, each training sample in the set of training samples comprising a pre-defined layout of a chip sample and a mask of the pre-defined layout;

using, for at least one training sample in the set of training samples, a pre-defined layout of a chip sample in the training sample as an input for a mask generation model, to obtain a predicted mask of the pre-defined layout as an output; inputting the predicted mask of the pre-defined layout into a wafer pattern prediction model, which is a photolithography physical model, to obtain a wafer pattern corresponding to the predicted mask of the pre-defined layout;

determining complexity of the predicted mask of the pre-defined layout based on a sum of perimeters of a plurality of graphics included in the pre-defined layout of the chip sample and a perimeter of the predicted mask of the pre-defined layout; and

adjusting a parameter of the mask generation model based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model.

According to a second aspect, an embodiment of the present disclosure provides a method for mask generation, including:

obtaining a chip layout; and

inputting the chip layout into a trained mask generation model to obtain a mask corresponding to the chip layout as an output, the mask generation model being obtained through training according to the method described in the first aspect.

According to a third aspect, an embodiment of the present disclosure provides an apparatus for training a mask generation model, including:

an obtaining module, configured to obtain a set of training samples, each training sample in the set of training samples comprising a pre-defined layout of a chip sample and a mask of the pre-defined layout;

a processing module, configured to use, for at least one training sample in the set of training samples, a pre-defined layout of a chip sample in the training sample as an input for a mask generation model, to obtain a predicted mask of the pre-defined layout as an output,

the processing module being further configured to input the predicted mask of the pre-defined layout into a wafer pattern prediction model, which is a photolithography physical model, to obtain a wafer pattern corresponding to the predicted mask of the pre-defined layout;

a determining module, configured to determine complexity of the predicted mask of the pre-defined layout based on a sum of perimeters of a plurality of graphics included in the pre-defined layout of the chip sample and a perimeter of the predicted mask of the pre-defined layout; and

a parameter adjustment module, configured to adjust a parameter of the mask generation model based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model.

According to a fourth aspect, an embodiment of the present disclosure provides an apparatus for mask generation, including:

an obtaining module, configured to obtain a chip layout; and

a processing module, configured to input the chip layout into a trained mask generation model to obtain a mask corresponding to the chip layout as an output, the mask generation model being obtained through training according to the method described in the first aspect.

According to a fifth aspect, an embodiment of the present disclosure provides a computer device, including: a processor and a memory, the memory being configured to store a computer program, and the processor being configured to invoke and run the computer program stored in the memory to perform the method described in the first aspect or the second aspect.

According to a sixth aspect, an embodiment of the present disclosure provides a computer-readable storage medium, including instructions that, when run on a computer program, cause the computer to perform the method described in the first aspect or the second aspect.

According to a seventh aspect, an embodiment of the present disclosure provides a computer program product including instructions. When the instructions are run on a computer, the computer is enabled to perform the method described in the first aspect or the second aspect.

In summary, in the embodiments of the present disclosure, a set of training samples is first obtained, for at least one training sample in the set of training samples, a pre-defined layout of a chip sample in the training sample is inputted into a mask generation model to obtain a predicted mask of the pre-defined layout as an output, and then the predicted mask of the pre-defined layout is inputted into a photolithography physical model to obtain a wafer pattern corresponding to the predicted mask of the pre-defined layout. Complexity of the predicted mask of the pre-defined layout is determined based on a sum of perimeters of a plurality of graphics included in the pre-defined layout of the chip sample and a perimeter of the predicted mask of the pre-defined layout. Then, a parameter of the mask generation model is adjusted based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model. In this way, when a model parameter of the mask generation model is adjusted, the model parameter is not only adjusted based on the pre-defined layout of the chip sample, the wafer pattern corresponding to the predicted mask of the pre-defined layout, the mask of the pre-defined layout, and the predicted mask of the pre-defined layout, but also adjusted based on the complexity of the predicted mask of the pre-defined layout. Therefore, complexity of the mask generated by the mask generation model can be reduced. In addition, since the complexity of the predicted mask of the pre-defined layout is determined based on the sum of perimeters of the plurality of graphics included in the pre-defined layout of the chip sample and the perimeter of the predicted mask of the pre-defined layout, the complexity of the predicted mask of the pre-defined layout depends only on shapes of the pre-defined layout and the predicted mask of the pre-defined layout. Therefore, the mask generation model obtained through training has high transferability, and a calculation amount in a model training process is low.

Further, in the embodiments of the present disclosure, the mask generation model is pre-trained, and a model parameter of the pre-trained mask generation model is used as an initial model parameter for subsequent training, so that the calculation amount is reduced, and a model converge is faster.

BRIEF DESCRIPTION OF THE DRAWINGS

FIG. 1 is a schematic diagram of an implementation scenario of a method for training a mask generation model and a method for mask generation according to an embodiment of the present disclosure.

FIG. 2 is a flowchart of a method for training a mask generation model according to an embodiment of the present disclosure.

FIG. 3 is a schematic diagram of a model training process according to an embodiment of the present disclosure.

FIG. 4 is a schematic diagram of a pre-defined layout of a chip sample, a predicted mask of the pre-defined layout of the chip sample, and a contour line of the predicted mask of the pre-defined layout of the chip sample.

FIG. 5 is a schematic diagram of a modified edge placement error.

FIG. 6 is a flowchart of a method for training a mask generation model according to an embodiment of the present disclosure.

FIG. 7 is a schematic diagram of a comparison of mask effects according to an embodiment of the present disclosure.

FIG. 8 is a schematic diagram of a comparison of mask effects according to an embodiment of the present disclosure.

FIG. 9 is a flowchart of a method for mask generation according to an embodiment of the present disclosure.

FIG. 10 is a schematic structural diagram of an apparatus for training a mask generation model according to an embodiment of the present disclosure.

FIG. 11 is a schematic structural diagram of an apparatus for mask generation according to an embodiment of the present disclosure.

FIG. 12 is a schematic block diagram of a computer device 300 according to an embodiment of the present disclosure.

DESCRIPTION OF EMBODIMENTS

The technical solutions in the embodiments of the present disclosure are clearly and completely described below with reference to accompanying drawings in the embodiments of the present disclosure. Apparently, the described embodiments are merely some rather than all of the embodiments of the present disclosure. All other embodiments obtained by a person of ordinary skill in the art based on embodiments in the embodiments of the present disclosure without creative efforts shall fall within the protection scope of the embodiments of the present disclosure.

In the specification, claims, and accompanying drawings of the embodiments of the present disclosure, the terms "first", "second", and the like are intended to distinguish between similar objects but do not necessarily indicate a specific order or sequence. The data used in such a way is interchangeable in proper circumstances, so that embodiments in the embodiments of the present disclosure described herein can be implemented in other orders than the order illustrated or described herein. Moreover, the terms "include", "contain" and any other variants mean to cover the non-exclusive inclusion. For example, a process, method, system, product, or device that includes a list of operations or units is not necessarily limited to those operations or units, but may include other operations or units not expressly listed or inherent to such a process, method, product, or device.

Before technical solutions of the embodiments of the present disclosure are described, relevant knowledge of the technical solutions of the embodiments of the present disclosure is explained below:

1. Artificial intelligence (AI): It is a theory, a method, a technology and an application system that uses a digital computer or a machine controlled by the digital computer to simulate, extend, and expand human intelligence, perceive the environment, acquire knowledge, and use knowledge to obtain an optimal result. In other words, the AI is a comprehensive technology in computer science. This technology attempts to understand the essence of intelligence and produce a new intelligent machine that can react in a manner similar to human intelligence. The AI is to study design principles and implementation methods of various intelligent machines, so that the machines have functions of perception, reasoning, and decision-making. The AI technology is a comprehensive discipline, relating to a wide range of fields, and involving both a hardware-level technology and a software-level technology. Basic AI technologies generally include technologies such as a sensor, a dedicated AI chip, cloud computing, distributed storage, a big data processing technology, an operating/interaction system, and electromechanical integration. AI software technologies mainly include several major directions such as a computer vision technology, a speech processing technology, a natural language processing technology, and machine learning/deep learning.

2. Machine learning (ML): It is a multi-field interdiscipline, and relates to a plurality of disciplines such as the probability theory, statistics, the approximation theory, convex analysis, and the algorithm complexity theory. The ML specializes in studying how a computer simulates or implements a human learning behavior to obtain new knowledge or skills, and reorganize an existing knowledge structure, so as to keep improving its performance. The ML is the core of the AI, is a basic way to make a computer intelligent, and is applied to various fields of AI. The ML and the deep learning generally include technologies such as an artificial neural network, a belief network, reinforcement learning, transfer learning, inductive learning, and learning from demonstrations.

3. Deep learning (DL): It is a branch of machine learning, and is an algorithm that attempts to perform high-level abstraction on data by using a plurality of processing layers including a complex structure or including a plurality of nonlinear transformations. The deep learning is learning an intrinsic rule and a representation level of training sample data. Information obtained in these learning processes greatly helps in the interpretation of data such as text, images, and sound. An ultimate objective of the deep learning is to enable a machine to have an analytical learning capability like a human being, and to recognize data such as text, images, and sound. The deep learning is a complex machine learning algorithm, and has effects in speech and image recognition that far exceed those in the previous related art.

Neural network (NN): It is a deep learning model that simulates a structure and a function of a biological neural network in the field of machine learning and cognitive science.

In the related art, complexity of a generated mask is high. To resolve this problem, in the embodiments of the present disclosure, when training a mask generation model, for at least one training sample in a set of training samples, a pre-defined layout of a chip sample in a training sample is inputted into the mask generation model, to obtain a predicted mask of the pre-defined layout as an output, and then the predicted mask of the pre-defined layout is inputted into a photolithography physical model to obtain a wafer pattern corresponding to the predicted mask of the pre-defined layout. The input to the mask generation model is the layout of the chip, typically represented as a 2D image, where each pixel value denotes the lithographic pattern information at the corresponding position. Each shape in the layout has clear dimensions and is used to define the locations of the components in the integrated circuit. The intermediate processing involves the model's internal computations, which usually include multiple convolutional layers and deconvolutional layers. The convolutional layers are responsible for feature extraction from the layout, such as edges, shapes, and local patterns, while the deconvolutional layers attempt to reconstruct the mask image based on these features. This process may also involve the application of activation functions, batch normalization layers, and skip connections to assist the model in learning more sophisticated and detailed mask generation patterns. The output of the mask generation model is the predicted mask image, also represented as a 2D image where each pixel value indicates whether light is allowed to pass at that location. The aim of mask generation is to ensure that when the lithographic process is performed, light can correctly form patterns on the wafer in accordance with the layout design. The output mask may require post-processing, such as binarization, to meet the requirements of the lithographic process. The photolithography physical model simulates the optical and chemical processes involved in photolithography to predict the final pattern printed on the wafer from a given mask. The input of the photolithography physical model may be: Mask pattern, the input to the photolithography physical model is usually a mask pattern, which is the design that needs to be transferred to the wafer. This mask pattern is typically represented as a binary or grayscale image where the transmittance of light is defined; Optical parameters, these include the wavelength of the light source, the numerical aperture of the lens, the coherence of the light source, and the distance between the mask and the wafer, among other factors that can affect the lithography process; Photoresist properties, the model also requires information about the photoresist properties, such as its sensitivity to light, the development process, and the profile it will take after the exposure and development steps; Process variables, variables such as focus, exposure dose, and other process parameters that influence the final pattern on the wafer. Intermediate processing of the photolithography physical model may be: Optical Simulation, the model performs optical simulation by calculating the light intensity distribution that would occur on the wafer surface given the mask pattern and the optical parameters. This involves using physics-based models that can account for diffraction, interference, and the interaction of light with the mask and photoresist; Chemical Simulation, After the optical simulation, there is a chemical simulation step to model the photoresist development process. This step transforms the light intensity distribution into a physical pattern on the wafer by simulating the chemical reactions that occur in the photoresist due to the exposure to light. Output of the photolithography physical model may be: Wafer Pattern, the output of the photolithography physical model is a simulated wafer pattern, which represents the final layout that would be printed on the wafer if the mask were to be used in an actual lithography process. This pattern can be compared to the desired layout to evaluate the quality of the mask and the lithography process.; Process Window, additionally, the model may output information about the process window, which describes the range of process variables (like focus and exposure dose) that result in an acceptable pattern on the wafer. A wide process window indicates a robust lithography process that is tolerant to variations in process parameters. The photolithography physical model's main goal is to accurately predict how the mask will behave in the photolithography process, allowing for the optimization of mask designs and process parameters to achieve the desired wafer patterns with high fidelity. The mask of the pre-defined layout represents the ideal mask design, optimized to reduce manufacturing costs, enhance the process window, and improve pattern fidelity. The mask of the pre-defined layout provides the correct solution for the training process. The predicted mask is a mask prediction output by the model when the layout as input, one of the objectives during model training is to make the predicted mask as close as possible to the mask of the pre-defined layout. Complexity of the predicted mask of the pre-defined layout is determined based on a sum of perimeters of a plurality of graphics included in the pre-defined layout of the chip sample and a perimeter of the predicted mask of the pre-defined layout. Then, a parameter of the mask generation model is adjusted based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model. In this way, in the embodiments of the present disclosure, when a model parameter of the mask generation model is adjusted, the model parameter is not only adjusted based on the pre-defined layout of the chip sample, the wafer pattern corresponding to the predicted mask of the pre-defined layout, the mask of the pre-defined layout, and the predicted mask of the pre-defined layout, but also adjusted based on the complexity of the predicted mask of the pre-defined layout. Therefore, complexity of the mask generated by the mask generation model can be reduced. In addition, since the complexity of the predicted mask of the pre-defined layout is determined based on the sum of perimeters of the plurality of graphics included in the pre-defined layout of the chip sample and the perimeter of the predicted mask of the pre-defined layout, the complexity of the predicted mask of the pre-defined layout depends only on shapes of the pre-defined layout and the predicted mask of the pre-defined layout. Therefore, the mask generation model obtained through training has high transferability, and a calculation amount in a model training process is low.

The embodiments of the present disclosure may be applicable to various scenarios that require mask generation, for example, large-scale integrated circuit layout optimization. The method for training a mask generation model and the method for mask generation provided in the embodiments of the present disclosure may be loaded into computational lithography software. A chip mask manufacturer may obtain a mask corresponding to a chip layout by inputting the chip layout, and the mask has low complexity, so that a mask with high quality can be provided for a subsequent chip photolithography process. For example, specifically, a photolithography mask with low mask complexity may be provided, which significantly reduces calculation time and manufacturing costs of the mask, and increases a process window for generating the mask by the mask generation model. The process window may be understood as tolerances for an exposure amount and a focus deviation. The method for training a mask generation model and the method for mask generation provided in the embodiments of the present disclosure may also be extended to fields such as computer vision image generation.

The application scenarios described below are merely configured for describing rather than limiting the embodiments of the present disclosure. During specific implementation, the technical solutions provided in the embodiments of the present disclosure are flexibly applicable according to an actual requirement.

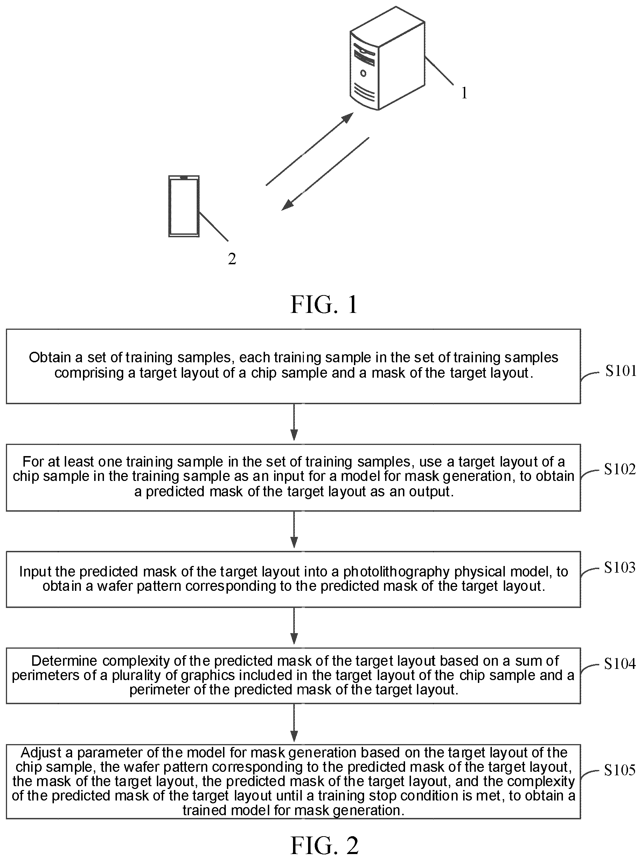

For example, FIG. 1 is a schematic diagram of an implementation scenario of a method for training a mask generation model and a method for mask generation according to an embodiment of the present disclosure. As shown in FIG. 1, the implementation scenario of the embodiments of the present disclosure involves a server 1 and a terminal device 2. The terminal device 2 may perform data communication on the server 1 through a communication network. The communication network may be a wireless or wired network such as an intranet, the Internet, a global system of mobile communications (GSM), a wideband code division multiple access (WCDMA), a 4G network, a 5G network, Bluetooth, Wi-Fi, or a call network.

In some possible implementations, the terminal device 2 refers to a type of device rich in human-computer interaction manners, capable of accessing the Internet, usually carrying various operating systems, and having a strong processing capability. The terminal device may be a terminal device such as a smartphone, a tablet computer, a portable notebook computer, or a desktop computer, or may be a phone watch, but is not limited thereto. In some embodiments of the present disclosure, various applications, for example, photolithography applications, are installed on the terminal device 2.

In some possible implementations, the terminal device 2 includes, but is not limited to, a mobile phone, a computer, a smart speech interaction device, a smart household appliance, an in-vehicle terminal, or the like.

The server 1 in FIG. 1 may be an independent physical server, or may be a server cluster or a distributed system formed by a plurality of physical servers, or may be a cloud server that provides a cloud computing service. This is not limited in the embodiments of the present disclosure. In the embodiments of the present disclosure, the server 1 may be a backend server of an application installed in the terminal device 2.

In some possible implementations, FIG. 1 exemplarily shows one terminal device and one server. Actually, terminal devices and servers of other numbers may be included. This is not limited in the embodiments of the present disclosure.

In some embodiments, when a mask corresponding to a chip layout needs to be obtained, the server 1 may first train a mask generation model according to the method provided in the embodiments of the present disclosure. Specifically, the method may be as follows: obtaining a set of training samples, each training sample in the set of training samples comprising a pre-defined layout of a chip sample and a mask of the pre-defined layout, for at least one training sample in the set of training samples, using the pre-defined layout of the chip sample in the training sample as an input of the mask generation model to obtain a predicted mask of the pre-defined layout as an output; inputting the predicted mask of the pre-defined layout into a wafer pattern prediction model, which is a photolithography physical model to obtain a wafer pattern corresponding to the predicted mask of the pre-defined layout; determining complexity of the predicted mask of the pre-defined layout based on a sum of perimeters of a plurality of graphics included in the pre-defined layout of the chip sample and a perimeter of the predicted mask of the pre-defined layout; and adjusting a parameter of the mask generation model based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model. After the trained mask generation model is obtained, a user may upload the chip layout by using an application for generating the mask installed and run on the terminal device 2. The terminal device 2 sends the uploaded chip layout to the server 1. After obtaining the chip layout, the server 1 inputs the chip layout into the trained mask generation model, and outputs a mask corresponding to the chip layout. Therefore, the mask corresponding to the chip layout can be obtained. In an embodiment, the training of the mask generation model may alternatively be performed by the terminal device, and the method for mask generation may also be performed by the terminal device. This is not limited in this embodiment.

The technical solution of the embodiments of the present disclosure is described in detail in the following:
FIG. 2 is a flowchart of a method for training a mask generation model according to an embodiment of the present disclosure. An execution body of this embodiment of the present disclosure is an apparatus having a model training function, for example, a model training apparatus. The model training apparatus may be, for example, a server. As shown in FIG. 2, the method may include the following operations:
S101: Obtain a set of training samples, each training sample in the set of training samples comprising a pre-defined layout of a chip sample and a mask of the pre-defined layout.

Specifically, obtaining the set of training samples may be receiving the set of training samples, and may alternatively be obtaining a preset number of training samples from a set of sample data to form the set of training samples. The set of sample data may be pre-stored.

Each training sample in the set of training samples includes the pre-defined layout of the chip sample and the mask of the pre-defined layout. A manner of obtaining the set of sample data is not limited in this embodiment.

In a possible implementation, the set of sample data may be first obtained by using a pixelation-based inverse lithography method. Correspondingly, in S101, obtaining the set of training samples may specifically be:
selecting a preset number of pieces of sample data from the set of sample data, and forming the set of training samples using the preset number of pieces of sample data.

S102: For at least one training sample in the set of training samples, use a pre-defined layout of a chip sample in the training sample as an input for a mask generation model, to obtain a predicted mask of the pre-defined layout as an output.

S103: Input the predicted mask of the pre-defined layout into a wafer pattern prediction model, which is a photolithography physical model, to obtain a wafer pattern corresponding to the predicted mask of the pre-defined layout.

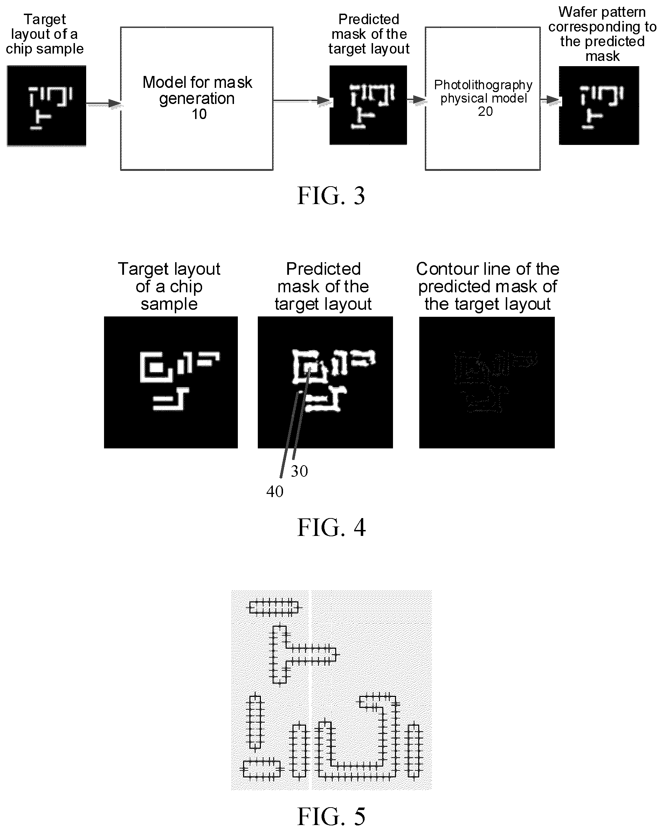

Specifically, FIG. 3 is a schematic diagram of a model training process according to an embodiment of the present disclosure. As shown in FIG. 3, after a set of training samples is obtained, for at least one training sample in the set of training samples, a pre-defined layout of a chip sample in the training sample is inputted into a mask generation model 10. The mask generation model 10 outputs a predicted mask of the pre-defined layout of the chip sample, and then the predicted mask of the pre-defined layout is inputted into a photolithography physical model 20 to output a wafer pattern corresponding to the predicted mask of the pre-defined layout. The photolithography physical model is a photolithography physical model with a process parameter being considered. In some embodiments, for each training sample in the set of training samples, through the processing process shown in FIG. 3, the pre-defined layout of the chip sample, the predicted mask of the pre-defined layout of the chip sample, and the wafer pattern corresponding to the predicted mask of the pre-defined layout of the chip sample in each training sample in the set of training samples may be obtained.

S104: Determine complexity of the predicted mask of the pre-defined layout based on a sum of perimeters of a plurality of graphics included in the pre-defined layout of the chip sample and a perimeter of the predicted mask of the pre-defined layout.

Specifically, low complexity of the mask may be defined as that the mask is substantially free of micro structures such as holes, isolated items, and sawteeth. Therefore, the complexity of the predicted mask of the pre-defined layout may be determined based on the sum of the perimeters of the plurality of graphics included in the pre-defined layout of the chip sample and the perimeter of the predicted mask of the pre-defined layout. In this embodiment, to ensure low complexity of the mask generated by the mask generation model, the complexity of the predicted mask of the pre-defined layout needs to be considered when a model parameter is adjusted during model training. Therefore, the complexity of the predicted mask of the pre-defined layout needs to be first determined. For ease of description, FIG. 4 is a schematic diagram of a pre-defined layout of a chip sample, a predicted mask of the pre-defined layout of the chip sample, and a contour line of the predicted mask of the pre-defined layout of the chip sample. As shown in FIG. 4, the pre-defined layout of the chip sample, the predicted mask of the pre-defined layout of the chip sample, and the contour line of the predicted mask of the pre-defined layout of the chip sample are sequentially from left to right. It can be seen from FIG. 4 that, the predicted mask of the pre-defined layout of the chip sample includes a hole and an isolated item. One hole 30 and one isolated item 40 are schematically marked in FIG. 4. The predicted mask of the pre-defined layout shown in FIG. 4 further includes another isolated item. The sum of the perimeters of the plurality of graphics included in the pre-defined layout refers to a sum of perimeters of all the graphics included in the pre-defined layout. The perimeter of the predicted mask of the pre-defined layout refers to a sum of lengths of contour lines of the predicted mask of the pre-defined layout. That the sum of the perimeters of the plurality of graphics included in the pre-defined layout is closer to the perimeter of the predicted mask of the pre-defined layout indicates that the complexity of the predicted mask of the pre-defined layout is lower. On the contrary, the complexity of the predicted mask of the pre-defined layout is higher.

In some embodiments, in a possible implementation, S104 may specifically be as follows:

S1041: Calculate contour lines of the predicted mask of the pre-defined layout based on a sum of a square of a first-order derivative of the predicted mask of the pre-defined layout in an x direction and a square of a first-order derivative of the predicted mask of the pre-defined layout in a y direction.

S1042: Perform summation on the contour lines of the predicted mask of the pre-defined layout to obtain the perimeter of the predicted mask of the pre-defined layout.

S1043: Obtain the sum of perimeters of the plurality of graphics L included in the pre-defined layout of the chip sample.

S1044: Obtain the complexity of the predicted mask of the pre-defined layout by calculation based on a result of dividing the perimeter of the predicted mask of the pre-defined layout by the sum of perimeters of the plurality of graphics L.

In some embodiments, in S1044, obtaining the complexity $L_c$ of the predicted mask of the pre-defined layout by calculation based on the result of dividing the perimeter of the predicted mask of the pre-defined layout by the sum of perimeters of the plurality of graphics L may specifically be represented by the following Formula (1):

$$L_c = \{\frac{1}{L} \sum_{x,y} 2 \times (Mask_{pred}^x(x,y)^2 + Mask_{pred}^y(x,y)^2) - 1\}^2 \quad (1),$$

where

$Mask_{pred}^x(x,y)$ represents a first-order derivative of a predicted mask $Mask_{pred}$ of a pre-defined layout in an x direction, $Mask_{pred}^y(x,y)$ represents a first-order derivative of the predicted mask $Mask_{pred}$ of the pre-defined layout in a y direction, L represents a sum of perimeters of all graphics included in the pre-defined layout, $2 \times (Mask_{pred}^x(x,y)^2 + Mask_{pred}^y(x,y)^2)$ represents a contour line of the predicted mask of the pre-defined layout, for example, the predicted mask of the pre-defined layout shown in FIG. 3. White represents a light-transmitting region, and black represents a light-shielding region or a light-blocking region. A pixel value of white is 1, and a pixel value of black is 0. Therefore, summation of the contour line of the predicted mask of the pre-defined layout is the perimeter of the predicted mask $Mask_{pred}$ of the pre-defined layout. When the perimeter of the predicted mask of the pre-defined layout is closer to the sum of the perimeters of the plurality of graphics included in the pre-defined layout, the complexity of the predicted mask of the pre-defined layout is lower, that is, $L_C$ is smaller. On the contrary, higher complexity of the predicted mask of the pre-defined layout indicates that $L_C$ is larger. It can be seen that the complexity of the mask depends only on a shape of the pre-defined layout and a shape of the mask, is independent of a specific optical physical model, and may be used in another optical physical model. Specifically, during use of the mask generation model obtained through training in the embodiments of the present disclosure, the chip layout is first obtained, and the chip layout is inputted into the trained mask generation model, to output the mask corresponding to the chip layout. During chip photolithography, the mask corresponding to the chip layout is inputted into the photolithography physical model, to obtain the wafer pattern corresponding to the predicted mask of the pre-defined layout. The photolithography physical model herein may be any photolithography physical model, and is not limited to a photolithography physical model used during training of the mask generation model, while in the related art, only the photolithography physical model used during training of the mask generation model can be used, so that transferability of the mask generation model in the embodiments of the present disclosure is high.

S105: Adjust a parameter of the mask generation model based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model. During the training of the mask generation model, the parameters (such as the weights of a neural network) must be adjusted so that the model can learn the mapping relationship from the chip layout (pre-defined layout) to mask design. This process is carried out by comparing the predicted mask and the wafer pattern generated by it through the photolithography physical model with the actual mask of the given chip layout and the desired wafer pattern. Specifically, the parameters are adjusted to: ensure that the predicted mask generated by the model is as close as possible to the actual mask of the given chip layout, maintaining the precision of the mask design, make the wafer pattern generated from the predicted mask through the photolithography physical model as close as possible to the ideal pattern of the target chip layout on the wafer, ensuring the accuracy of the lithography process, keep the complexity of the predicted mask at a relatively low level to reduce the difficulty and cost of mask manufacturing while guaranteeing the quality of the lithographic patterns. This series of adjustments and comparisons continues until a pre-defined training stop condition is met (such as reaching a predetermined number of training iterations or the loss function value falling below a preset threshold), at which point the training stops. The goal is to obtain a trained mask generation model that can produce low-complexity masks when later applied to chip layout mask design, supporting efficient lithography and chip fabrication with high-quality masks.

Specifically, after the complexity of the predicted mask of the pre-defined layout is determined, the parameter of the mask generation model may be adjusted based on the pre-defined layout of each chip sample in the set of training samples, the wafer pattern corresponding to the predicted mask of the pre-defined layout of the chip sample, the mask of the pre-defined layout of the chip sample, the predicted mask of the pre-defined layout of the chip sample, and the complexity of the predicted mask of the pre-defined layout of the chip sample that are obtained in a current iteration process, until the training stop condition is met. The parameter of the mask generation model may be adjusted through gradient descent, so that the wafer pattern corresponding to the predicted mask of the pre-defined layout of the chip sample and the pre-defined layout of the chip sample are as close as possible, the mask of the pre-defined layout of the chip sample and the predicted mask of the pre-defined layout of the chip sample are as close as possible, and the complexity of the predicted mask of the pre-defined layout of the chip sample is reduced (for example, the complexity of the predicted mask is less than a preset threshold), to finally obtain the trained mask generation model.

The mask may also be referred to as a photomask. The concepts of the two are the same.

In some embodiments, in a possible implementation, in S105, adjusting the parameter of the mask generation model based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout may specifically be:

S1051: Construct a first loss function based on the pre-defined layout of the chip sample and the wafer pattern corresponding to the predicted mask of the pre-defined layout.

S1052: Construct a second loss function based on the mask of the pre-defined layout and the predicted mask of the pre-defined layout.

S1053: Construct a composite loss function based on the first loss function, the second loss function, and the complexity of the predicted mask of the pre-defined layout.

In some embodiments, S1053 may specifically be as follows: obtain the composite loss function by calculation based on a sum of a product of a first parameter and the first loss function, a product of a second parameter and the complexity of the predicted mask of the pre-defined layout, and the second loss function.

In a possible implementation, the composite loss function L calculated based on the sum of the product of the first parameter and the first loss function, the product of the second parameter and the complexity of the predicted mask of the pre-defined layout, and the second loss function may specifically be represented by the following Formula (2):

$$L = |\text{Mask}_{\text{pred}} - \text{Mask}|^2 + \alpha * L_{\text{total}} + \beta * L_c \quad (2),$$

where

Mask represents the mask of the pre-defined layout, $\text{Mask}_{\text{pred}}$ represents the predicted mask of the pre-defined layout, $L_{\text{total}}$ represents the first loss function, $|\text{Mask}_{\text{pred}} - \text{Mask}|^2$ represents the second loss function, $\alpha$ is the first parameter, $\beta$ represents the second parameter, $\alpha$ and $\beta$ are adjustable parameters, and $L_C$ represents the complexity of the predicted mask of the pre-defined layout, which may specifically be obtained through calculation by using the foregoing Formula (1).

In a possible implementation, $L_{\text{total}}$ may be represented by the following Formula (3):

$$L_{\text{total}} = \sum_{\mu}^{U} \sum_{q}^{Q} \xi(h_{\mu}) \zeta(t_q)(L_{\text{Aerial}} + \alpha R_D + \kappa R_{TV} + \beta L_{\text{MEPE}}) \quad (3),$$

where

$\xi(h_{\mu})$ represents an out of focus process parameter distribution function, $\xi(h_{\mu}) = \exp\{-\frac{(h_{\mu})^2}{2(\sigma_h)^2}\}$, $h_{\mu}$ represents that a wafer is located at a distance h from a focal plane of a photolithography machine, and $\sigma_h$ represents distribution function widening. In some embodiments, in an embodiment, $h_{\mu}=[h_1, h_2, h_3]=[-80\,\text{nm}, 0\,\text{nm}, 80\,\text{nm}]$, $\mu$ is a subscript of h, U represents that an array length of $h_{\mu}$, which may be 3, and $\sigma_h$ may be 80; $\zeta(t_q)$ represents an exposure dose deviation process parameter distribution function, $\zeta(t_q) = \exp\{-\frac{(t_q)^2}{2(\sigma_q)^2}\}$, $t_q$ represents an exposure dose deviation of the photolithography machine, $\sigma_q$ represents distribution function widening. In an embodiment, $t_q=[t_1, t_2, t_3]=[-0.1, 0.0, 0.1]$, q is a subscript of t, Q represents an array length of $t_q$, which may be 3 herein, and $\sigma_q$ may be 0.1; $\alpha$, $\kappa$, and $\beta$ represent adjustable coefficients for balancing relative values of the loss functions, which may be, for example, 0.025, 0.06, and 2 respectively. $R_D$ represents a discrete regular term, $R_{TV}$ represents a total variation regular term, $L_{\text{MEPE}}$ represents a modified edge placement error loss function, and $L_{\text{Aerial}}$ represents an imaging error.

Specifically, the imaging error $L_{\text{Aerial}}$ represents an error between a wafer pattern Z corresponding to the predicted mask of the pre-defined layout and a pre-defined layout $Z_t$, which may be obtained through calculation by using the following Formula (4):

$$L_{\text{Aerial}} = \frac{1}{L}\sum_{x=1}^{N} \sum_{y=1}^{N}(Z(x, y; h_{\mu}, t_q) - Z_t(x, y))^{\gamma} \quad (4),$$

where

L represents a sum of perimeters of all graphics in a pre-defined layout, a dimension of the imaging error is a unit of length, and is consistent with a dimension of a chip node size. $\gamma$ is an adjustable parameter, which may be, for example, 2. $h_{\mu}$ and $t_q$ have the same meaning as those in the foregoing Formula (3).

The wafer pattern Z corresponding to the predicted mask of the pre-defined layout is obtained through calculation by using a photolithography physical model. The photolithography physical model may be, for example, a Hopkins diffraction photolithography physical model of a partially coherent imaging system. The model obtains a light intensity distribution $I(x, y; h_{\mu})$ imaged on the wafer, and the light intensity distribution is obtained by convolving a mask M and a photolithography system kernel function h. The kernel function is obtained by performing singular value decomposition on a cross transfer coefficient of the photolithography system (for example, a 193 nm annular light source). In some embodiments, the light intensity distribution $I(x, y; h_{\mu})$ can be obtained through calculation by using the following Formula (5):

$$I(x, y; h_{\mu}) = \sum_{k=1}^{K} \omega_k(h_{\mu})|M(x, y) \otimes h_k(x, y; h_{\mu})|^2 \quad (5),$$

where

$h_k$ and $\omega_k$ are respectively a $k^{\text{th}}$ kernel function and a corresponding weight coefficient after singular value decomposition. In this embodiment of the present disclosure, first 24 kernel functions and corresponding weight coefficients after singular value decomposition may be used, that is, K=24, and $h_{\mu}$ has the same meaning as that in the foregoing Formula (3).

An imaging pattern on a wafer (namely, the wafer pattern Z) is obtained by transforming the light intensity distribution $I(x, y; h_{\mu})$ through a sigmoid function. The wafer pattern Z may be obtained through calculation by using the following Formula (6):

$$Z(x,y;h_\mu,t_q) = sig(I;h_\mu,t_q) = \frac{1}{1+exp(-\theta_Z\times(I(x,y;h_\mu)-I_{th}/(1+t_q)))} \quad (6),$$

where

$\theta_Z$ and $I_{th}$ may be 50 and 0.225 respectively, and $h_\mu$ and $t_q$ has the same meaning as in the foregoing Formula (3).

Pixel values of the mask obtained through optimization are in a continuous distribution between 0 and 1, and there is an error between the continuous distribution and a discrete distribution of the binary mask. A difference between the two can be characterized by using the discrete regular term $R_D$, which can be obtained through calculation by using the following Formula (7):

$$R_D = \frac{1}{L}\sum_{x=1}^{N}\sum_{y=1}^{N}[1-(1-2M(x,y))^2] \quad (7)$$

A total variation regular term $R_{TV}$ may be calculated by using the following Formula (8):

$$R_{TV} = \frac{1}{L}\left(\left\|\frac{\partial f}{\partial x}\right\|_1 + \left\|\frac{\partial f}{\partial y}\right\|_1\right) = \frac{1}{L}(\|D\oplus f\|_1 + \|f\oplus D^T\|_1), \ f = |M-Z_t| \quad (8)$$

D represents a matrix first-order derivative, T represents matrix transpose, $\|.\|_1$ represents 1-norm, $\oplus$ represents a matrix product, M represents the mask, and Zt represents the pre-defined layout.

The modified edge placement error loss function $L_{MEPE}$ may be obtained through calculation by using the following Formula (9):

$$L_{MEPE} = L_{Aerial-MEPE} + \alpha R_{D-MEPE} + \kappa R_{TV-MEPE} \quad (9),$$

where

$L_{Aerial-MEPE}$ represents an imaging edge placement error, $R_{D-MEPE}$ represents a discrete regular term of an edge placement error, and $R_{TV-MEPE}$ represents a total variation regular term of the edge placement error.

The definition of the imaging edge placement error $L_{Aerial-MEPE}$ may be the following Formula (10):

$$L_{Aerial-MEPE} = \frac{1}{L}\sum_{x=1}^{N}\sum_{y=1}^{N} MEPE\odot(Z(x,y;h_\mu,t_q)-Z_t(x,y))^\gamma \quad (10),$$

where

an MEPE represents a modified edge placement error. FIG. 5 is a schematic diagram of a modified edge placement error. As shown in FIG. 5, a matrix formed by black short line data points represents the modified edge placement error, a length of the black short line represents a length of the edge placement error, and a plurality of graphics formed by black long lines together form the pre-defined layout of the chip sample, and $\odot$ represents multiplication of corresponding elements of the matrix formed by the black short line data points.

The definition of a discrete regular term of an edge placement error $R_{D-MEPE}$ may be the following Formula (11):

$$R_{D-MEPE} = \frac{1}{L}\sum_{x=1}^{N}\sum_{y=1}^{N}[1-(1-2M(x,y)\odot MEPE)^2] \quad (11)$$

The definition of a total variation regular term of an edge placement error $R_{TV-MEPE}$ may be the following Formula (12):

$$R_{TV-MEPE} = \frac{1}{L}\left(\left\|\frac{\partial f\odot MEPE}{\partial x}\right\|_1 + \left\|\frac{\partial f\odot MEPE}{\partial y}\right\|_1\right) = \frac{1}{L}(\|D\oplus(f\odot MEPE)\|_1 +$$

$$\|(f\odot MEPE)\oplus D^T\|_1) \quad (12)$$

S1054: Adjust the parameter of the mask generation model through a gradient descent algorithm based on the composite loss function until the training stop condition is met.

Specifically, the composite loss function may be represented by the following Formula (2):

$$L = |\text{Mask}_{\text{pred}} - \text{Mask}|^2 + \alpha * L_{\text{total}} + \beta * L_c \quad (2),$$

where

Mask represents a mask of a pre-defined layout, $\text{Mask}_{\text{pred}}$ represents a predicted mask of a pre-defined layout, $L_{\text{total}}$ represents a first loss function, $|\text{Mask}_{\text{pred}} - \text{Mask}|^2$ represents a second loss function, $\alpha$ is a first parameter, $\beta$ represents a second parameter, $\alpha$ and $\beta$ are adjustable parameters, and $L_c$ represents complexity of the predicted mask of the pre-defined layout, which may specifically be obtained through calculation by using the foregoing Formula (1).

The first loss function is obtained through calculation based on the pre-defined layout of the chip sample and the wafer pattern corresponding to the predicted mask of the pre-defined layout, and the second loss function is obtained through calculation based on the mask of the pre-defined layout and the predicted mask of the pre-defined layout. The composite loss function includes three parts. A damage function is minimized by the gradient descent algorithm, so that the parameter of the mask generation model is continuously adjusted, and the wafer pattern corresponding to the predicted mask of the pre-defined layout of the chip sample and the pre-defined layout of the chip sample are as close as possible, and the mask of the pre-defined layout of the chip sample and the predicted mask of the pre-defined layout of the chip sample are as close as possible. In addition, the complexity of the predicted mask of the pre-defined layout of the chip sample is reduced (for example, the complexity of the predicted mask is less than a preset threshold).

In some embodiments, in a possible implementation, S1054 may specifically be as follows:

S10541: Obtain a gradient of the composite loss function by calculation based on the parameter of the mask generation model in a current iteration process.

Specifically, the composite loss function shown in Formula (2) is used as an example, the gradient of the composite loss function may be calculated by using the following Formula (13):

$$\frac{\partial L}{\partial w} = \frac{\partial L_{\text{fit}}}{\partial w} + \alpha \times \frac{\partial L_{\text{total}}}{\partial \text{Mask}_{\text{pred}}} \times \frac{\partial \text{Mask}_{\text{pred}}}{\partial w} + \beta \times \frac{\partial L_{\text{cl}}}{\partial \text{Mask}_{\text{pred}}} \times \frac{\partial \text{Mask}_{\text{pred}}}{\partial w} \quad (13),$$

where

w represents a parameter of a mask generation model in a current iteration process, and when the mask generation model is a deep learning model, the parameter of the mask generation model is a neuron weight parameter, $\frac{\partial L_{\text{cl}}}{\partial \text{Mask}_{\text{pred}}}$ can be obtained by using automatic differentiation, and $L_{\text{fit}}$ represents a second loss function.

S10542: Adjust the parameter of the mask generation model based on an optimization direction and an optimization step size of the gradient descent algorithm until the training stop condition is met.

Specifically, the training stop condition may be that a preset number of iterative training times is reached, or may be that a gradient of the composite loss function reaches a preset value, or another training stop condition. This is not limited in this embodiment.

In some embodiments, in an embodiment, the mask generation model in this embodiment may be a pre-trained model. Correspondingly, the method in this embodiment may further include:

S106: Obtain a set of sample data, each sample data in the set of sample data comprising a pre-defined layout of a chip sample and a mask of the pre-defined layout of the chip sample.

In some embodiments, in S106, obtaining a set of sample data may specifically be: the set of sample data is obtained by using a pixelation-based inverse lithography method.

Correspondingly, in S101, obtaining the set of training samples may specifically be:

selecting a preset number of pieces of sample data from the set of sample data, and forming the set of training samples using the preset number of pieces of sample data.

S107: Train a deep learning model based on the set of sample data to obtain the mask generation model.

In this embodiment, the mask generation model is pre-trained. A process of pre-training the mask generation model herein may specifically be: obtaining a set of training samples, each training sample in the set of training samples comprising a pre-defined layout of a chip sample and a mask of the pre-defined layout, for at least one training sample in the set of training samples, using the pre-defined layout of the chip sample in the training sample as an input for a mask generation model to obtain a predicted mask of the pre-defined layout as an output; calculating a loss function based on the mask of the pre-defined layout of the chip sample and the predicted mask of the pre-defined layout of the chip sample; and adjusting a parameter of the mask generation model based on the loss function until a training stop condition is met, to obtain a trained mask generation model.

In this embodiment, pre-training is performed on the mask generation model, and a model parameter of the pre-trained mask generation model is used as an initial model parameter and then trained, so that the model parameter can be first imported, so that the calculation amount is reduced and a model converge is faster.

In some embodiments, the mask generation model in this embodiment may include an encoder and a decoder. The encoder includes a plurality of convolutional neural network layers, and the decoder includes a plurality of deconvolutional neural network layers. A specific structure is described in detail in the following embodiments.

In the method for training a mask generation model provided in this embodiment, the set of training samples is first obtained, for at least one training sample in the set of training samples, the pre-defined layout of the chip sample in the training sample is inputted into the mask generation model to obtain the predicted mask of the pre-defined layout, and then the predicted mask of the pre-defined layout is inputted into the photolithography physical model to obtain the wafer pattern corresponding to the predicted mask of the pre-defined layout. Complexity of the predicted mask of the pre-defined layout is determined based on a sum of perimeters of a plurality of graphics included in the pre-defined layout of the chip sample and a perimeter of the predicted mask of the pre-defined layout. Then, a parameter of the mask generation model is adjusted based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model. In this way, when a model parameter of the mask generation model is adjusted, the model parameter is not only adjusted based on the pre-defined layout of the chip sample, the wafer pattern corresponding to the predicted mask of the pre-defined layout, the mask of the pre-defined layout, and the predicted mask of the pre-defined layout, but also adjusted based on the complexity of the predicted mask of the pre-defined layout. Therefore, complexity of the mask generated by the mask generation model can be reduced. In addition, since the complexity of the predicted mask of the pre-defined layout is determined based on the sum of perimeters of the plurality of graphics included in the pre-defined layout of the chip sample and the perimeter of the predicted mask of the pre-defined layout, the complexity of the predicted mask of the pre-defined layout depends only on shapes of the pre-defined layout and the predicted mask of the pre-defined layout. Therefore, the mask generation model obtained through training has high transferability, and a calculation amount in a model training process is low.

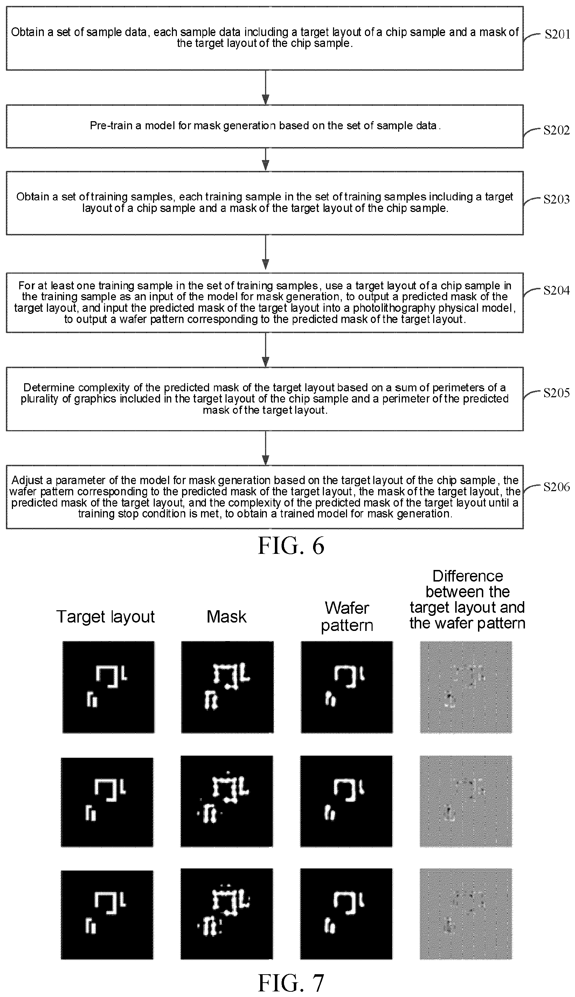

With reference to FIG. 6, a specific embodiment is used below to describe in detail a process of training the mask generation model.

FIG. 6 is a flowchart of a method for training a mask generation model according to an embodiment of the present disclosure. An execution body of the method may be a server. As shown in FIG. 6, the method may include:
S201: Obtain a set of sample data, each sample data in the set of sample data comprising a pre-defined layout of a chip sample and a mask of the pre-defined layout of the chip sample.

Specifically, the set of sample data may be obtained by using a pixelation-based inverse lithography method. A specific obtaining process is described in detail in the following embodiments.

S202: Pre-train a deep learning mask generation model based on the set of sample data.

In this embodiment, the mask generation model is pre-trained. A process of pre-training the mask generation model herein may specifically be: obtaining a set of training samples, each training sample in the set of training samples comprising a pre-defined layout of a chip sample and a mask of the pre-defined layout, for at least one training sample in the set of training samples, using the pre-defined layout of the chip sample in the training sample as an input for a mask generation model to obtain a predicted mask of the pre-defined layout as an output; calculating a loss function based on the mask of the pre-defined layout of the chip sample and the predicted mask of the pre-defined layout of the chip sample; and adjusting a parameter of the mask generation model based on the loss function until a training stop condition is met, to obtain a trained mask generation model. The mask generation model herein may be a deep learning model. After pre-training is completed, a parameter of the pre-trained mask generation model may be obtained, which may specifically be a neuron weight parameter of the mask generation model.

S203: Obtain a set of training samples, each training sample in the set of training samples comprising a pre-defined layout of a chip sample and a mask of the pre-defined layout of the chip sample.

Specifically, after the mask generation model is obtained through pre-training, a neuron weight parameter of the pre-trained mask generation model is initialized as a to-be-trained mask generation model, that is, the neuron weight parameter of the pre-trained mask generation model is used as an initialized weight parameter of the to-be-trained mask generation model. The obtaining the set of training samples may be selecting a preset number of pieces of sample data from the set of sample data, and forming the set of training samples using the preset number of pieces of sample data.

S204: For at least one training sample in the set of training samples, use a pre-defined layout of a chip sample in the training sample as an input of the mask generation model, to output a predicted mask of the pre-defined layout, and input the predicted mask of the pre-defined layout into a wafer pattern prediction model, which is a photolithography physical model, to output a wafer pattern corresponding to the predicted mask of the pre-defined layout.

Specifically, for each training sample in the set of training samples in the set of training samples, through the processing process shown in FIG. 3, the pre-defined layout of the chip sample, the predicted mask of the pre-defined layout of the chip sample, and the wafer pattern corresponding to the predicted mask of the pre-defined layout of the chip sample in each training sample in the set of training samples may be obtained.

S205: Determine complexity of the predicted mask of the pre-defined layout based on a sum of perimeters of a plurality of graphics included in the pre-defined layout of the chip sample and a perimeter of the predicted mask of the pre-defined layout.

Specifically, low complexity of the mask may be defined as that the mask is substantially free of micro structures such as holes, isolated items, and sawteeth. Therefore, the complexity of the predicted mask of the pre-defined layout may be determined based on the sum of the perimeters of the plurality of graphics included in the pre-defined layout of the chip sample and the perimeter of the predicted mask of the pre-defined layout.

In some embodiments, in a possible implementation, S205 may specifically be as follows:

S2051: Calculate contour lines of the predicted mask of the pre-defined layout based on a sum of a square of a first-order derivative of the predicted mask of the pre-defined layout in an x direction and a square of a first-order derivative of the predicted mask of the pre-defined layout in a y direction.

S2052: Perform summation on the contour lines of the predicted mask of the pre-defined layout to obtain the perimeter of the predicted mask of the pre-defined layout.

S2053: Obtain the sum of perimeters of the plurality of graphics L included in the pre-defined layout of the chip sample.

S2054: Obtain the complexity of the predicted mask of the pre-defined layout by calculation based on a result of dividing the perimeter of the predicted mask of the pre-defined layout by the sum of perimeters of the plurality of graphics L.

In some embodiments, in S2054, obtain the complexity of the predicted mask of the pre-defined layout by calculation based on the result of dividing the perimeter of the predicted mask of the pre-defined layout by the sum of perimeters of the plurality of graphics L may specifically be represented by the foregoing Formula (1).

S206: Adjust a parameter of the mask generation model based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model.

In some embodiments, in a possible implementation, in S206, adjust the parameter of the mask generation model based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout may specifically be:

S2061: Construct a first loss function based on the pre-defined layout of the chip sample and the wafer pattern corresponding to the predicted mask of the pre-defined layout.

S2062: Construct a second loss function based on the mask of the pre-defined layout and the predicted mask of the pre-defined layout.

S2063: Construct a composite loss function based on the first loss function, the second loss function, and the complexity of the predicted mask of the pre-defined layout.

In a possible implementation, construct a composite loss function L based on the first loss function, the second loss function, and the complexity of the predicted mask of the pre-defined layout may specifically be represented by the foregoing Formula (2).

In a possible implementation, $L_{total}$ can be represented by the foregoing Formula (3).

S2064: Adjust the parameter of the mask generation model through a gradient descent algorithm based on the composite loss function until the training stop condition is met.

The first loss function is obtained through calculation based on the pre-defined layout of the chip sample and the wafer pattern corresponding to the predicted mask of the pre-defined layout, and the second loss function is obtained through calculation based on the mask of the pre-defined layout and the predicted mask of the pre-defined layout. The composite loss function includes three parts. A damage function is minimized by the gradient descent algorithm, so that the parameter of the mask generation model is continuously adjusted, and the wafer pattern corresponding to the predicted mask of the pre-defined layout of the chip sample and the pre-defined layout of the chip sample are as close as possible, and the mask of the pre-defined layout of the chip sample and the predicted mask of the pre-defined layout of the chip sample are as close as possible. In addition, the complexity of the predicted mask of the pre-defined layout of the chip sample is reduced (for example, the complexity of the predicted mask is less than a preset threshold).

In some embodiments, in a possible implementation, S2064 may specifically be as follows:

S20641: Calculate a gradient of the composite loss function based on the parameter of the mask generation model in a current iteration process.

Specifically, the composite loss function shown in Formula (2) is used as an example, the gradient of the composite loss function may be calculated by using the following Formula (13):

$$\frac{\partial L}{\partial w} = \frac{\partial L_{fit}}{\partial w} + \alpha \times \frac{\partial L_{total}}{\partial Mask_{pred}} \times \frac{\partial Mask_{pred}}{\partial w} + \beta \times \frac{\partial L_{cl}}{\partial Mask_{pred}} \times \frac{\partial Mask_{pred}}{\partial w} \quad (13),$$

where

w represents a parameter of a mask generation model in a current iteration process, and when the mask generation model is a deep learning model, the parameter of the mask generation model is a neuron weight parameter, $\frac{\partial L_{cl}}{\partial \text{Mask}_{pred}}$ can be obtained by using automatic differentiation, and $L_{fit}$ represents a second loss function.

S20642: Adjust the parameter of the mask generation model based on an optimization direction and an optimization step size of the gradient descent algorithm until the training stop condition is met.

Specifically, the foregoing w is adjusted until the training stop condition is met. The training stop condition may be that a preset number of iterative training times is reached, or another training stop condition. This is not limited in this embodiment.

In the method for training a mask generation model provided in this embodiment, when the mask generation model is trained, the pre-defined layout of the chip sample in the training sample is inputted into the mask generation model to obtain the predicted mask of the pre-defined layout, and then the predicted mask of the pre-defined layout is inputted into the photolithography physical model to obtain the wafer pattern corresponding to the predicted mask of the pre-defined layout. The complexity of the predicted mask of the pre-defined layout is determined based on the sum of the perimeters of the plurality of graphics included in the pre-defined layout of the chip sample and the perimeter of the predicted mask of the pre-defined layout, and the composite loss function is constructed based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout, to bring the wafer pattern corresponding to the predicted mask of the pre-defined layout closer to the pre-defined layout of the chip sample by gradient descent, so that the mask of the pre-defined layout of the chip sample is as close as possible to the predicted mask of the pre-defined layout of the chip sample, In addition, complexity of the predicted mask of the pre-defined layout of the chip sample is reduced. Therefore, complexity of the mask generated by the mask generation model obtained through training is reduced. Moreover, since the complexity of the predicted mask of the pre-defined layout is determined based on the sum of the perimeters of the plurality of graphics included in the pre-defined layout of the chip sample and the perimeter of the predicted mask of the pre-defined layout, the complexity of the predicted mask of the pre-defined layout depends only on the pre-defined layout and a shape of the predicted mask of the pre-defined layout. Therefore, the mask generation model obtained through training has high transferability, and a calculation amount in a model training process is low.

The following describes in detail that the set of sample data is obtained by using the pixelation-based inverse lithography method. A method of obtaining the set of sample data may include:

S1: Determine a loss function.

Specifically, the loss function $L_{total}$ may be represented by the following Formula (3):

$$L_{total} = \sum_{\mu}^{U} \sum_{q}^{Q} \xi(h_{\mu}) \zeta(t_{q})(L_{Aerial} + \alpha R_{D} + \kappa R_{TV} + \beta L_{MEPE}) \quad (3),$$

where
the definition of parameters in the loss function may be found in the description of the embodiment shown in FIG. 1, and details are not described herein again.

S2: Initialize a mask.

Specifically, in this embodiment, a modified chip layout is used, that is, $\overline{M}_0 = w_1 Z_t + w_2$, where $Z_t$ is a pre-defined layout of a chip sample, $w_1$ and $w_2$ can be set to 0.98 and 0.1 respectively, so that the calculated gradient is not be too small, which is beneficial to a subsequent gradient descent. In addition, discontinuous optimization of a binary mask is very difficult. Therefore, in this embodiment, a discrete mask optimization problem is transformed into a continuous optimization problem by using the sigmoid function, that is, $M_0 = \frac{1}{1+\exp(-\theta_M \times (\overline{M}_0 - M_{th}))}$, where $\theta_M$ and $M_{th}$ can be 4 and 0.225 respectively. The sigmoid function herein may also function as a filter to filter out micro complex structures (islands, hollows, sawteeth, and stretched items) in a generated mask, thereby increasing manufacturability of the mask.

S3: Calculate an optimization direction.

For the steepest descent method, an optimization direction is the gradient $\frac{\partial L_{total}}{\partial \overline{M}}$ of the loss function $L_{total}$ about the mask. For a conjugate gradient method, an initial descent direction is $\frac{\partial L_{total}}{\partial \overline{M}}$, a subsequent descent direction retains the optimization direction of a previous step, and a conjugate gradient factor $\eta_k$ is automatically adjusted to avoid optimization stagnation. The gradient of the loss function $L_{total}$ may be defined by the following Formula (14):

$$\frac{\partial L_{total}}{\partial \overline{M}} = \sum_{\mu}^{U} \sum_{q}^{Q} \xi(h_{\mu})\zeta(t_q)(\frac{\partial L_{Aerial}}{\partial \overline{M}} + \alpha \frac{\partial R_D}{\partial \overline{M}} + \kappa \frac{\partial R_{TV}}{\partial \overline{M}} + \beta \frac{\partial L_{Aerial-MEPE}}{\partial \overline{M}} + \alpha\beta \frac{\partial R_{D-MEPE}}{\partial \overline{M}} +$$

$$\kappa\beta \frac{\partial R_{TV-MEPE}}{\partial \overline{M}}) \quad (14)$$

$$M = \frac{1}{1+\exp(-\theta_M \times (\overline{M}-M_{th}))}, \text{ where } \theta_M \text{ and } M_{th} \text{ can be 4 and 0.225 respectively.}$$

The gradient of the imaging error $L_{Aerial}$ may be defined by the following Formula (15):

$$\frac{\partial L_{Aerial}}{\partial \overline{M}} = \frac{1}{L}\gamma(Z - Z_t)^{\gamma-1} \odot \frac{\partial Z}{\partial M} \odot \frac{\partial M}{\partial \overline{M}}$$

$$= \frac{1}{L}\gamma\theta_M\theta_Z \ \{H^{flip} \otimes [(Z - Z_t)^{\gamma-1} \odot Z \odot (1 - Z) \odot (M \otimes H^*)] + (H^{flip})^* \otimes [(Z -$$

$$Z_t)^{\gamma-1} \odot Z \odot (1 - Z) \odot (M \otimes H)]\} \odot M \odot (1 - M) \quad (15)$$

$\theta_M$ and $\theta_Z$ are taken 4 and 50 respectively, $H^*$ is a complex conjugate of a photolithography system kernel function H, $H^{flip}$ is obtained by flipping H for 180°, $\otimes$ represents a matrix convolution operation, and L represents a sum of perimeters of all graphics in a pre-defined layout.

The gradient of the discrete regular term $R_D$ may be defined by the following Formula (16):

$$\frac{\partial R_D}{\partial \overline{M}} = \frac{\partial R_D}{\partial M} \odot \frac{\partial M}{\partial \overline{M}} = \frac{1}{L}\theta_M(-8 \times M + 4) \odot M \odot (1 - M) \quad (16)$$

The gradient of the total variation regular term $R_{TV}$ may be defined by the following Formula (17):

$$\frac{\partial R_{TV}}{\partial \overline{M}} = \frac{\partial R_{TV}}{\partial f} \odot \frac{\partial f}{\partial M} \odot \frac{\partial M}{\partial \overline{M}}$$

$$= \frac{1}{L}\theta_M[D^T \oplus sign(D \oplus f) + sign(f \oplus D^T) \oplus D] \odot sign(M - Z_t) \odot M \odot (1 - M) \quad (17),$$

where
sign represents a sign function, that is, sign(x)=0 and x=0; sign(x)=1, x > 0; and sign(x)=-1, x < 0

The gradient of the imaging edge placement error $L_{Aerial-MEPE}$ may be defined by the following Formula (18):

$$\frac{\partial L_{Aerial-MEPE}}{\partial \overline{M}} = \frac{\partial L_{Aerial}}{\partial \overline{M}} \odot MEPE \quad (18)$$

The gradient of the discrete regular term of the edge placement error $R_{D-MEPE}$ may be defined by the following Formula (19):

$$\frac{\partial R_{D-MEPE}}{\partial \overline{M}} = \frac{\partial RM_{D-MEPE}}{\partial M} \odot \frac{\partial M}{\partial \overline{M}} = \frac{1}{L} \times \theta_M(-8 \times MEPE \odot M + 4) \odot M \odot (1 - M) \quad (19)$$

The gradient of the total variation regular term of the edge placement error $R_{TV\text{-}MEPE}$ may be defined by the following Formula (20):

$$\frac{\partial R_{TV-MEPE}}{\partial \overline{M}} = \frac{\partial R_{TV-MEPE}}{\partial f} \odot \frac{\partial f}{\partial M} \odot \frac{\partial M}{\partial \overline{M}}$$

$$= \frac{1}{L}\theta_M[D^T \oplus \text{sign}(D \oplus (MEPE \odot f)) +$$

$$\text{sign}((MEPE \odot f) \oplus D^T) \oplus D] \odot \text{sign}(M - Z_t) \odot M \odot (1 - M) \quad (20)$$

S4: Update the mask based on the optimization direction.

Specifically, an optimization step size $\omega_k = \dfrac{\varepsilon}{\max(|V_k|)}$ may be used, where a small value, for example, 0.1, is configured for a step size factor $\varepsilon$. The mask is updated based on the optimization direction, specifically, the pixel value of the mask is updated. The updated pixel value of the mask may exceed 1 or be less than 0. The mask value may be fixed to between 0 and 1 through the sigmoid function. Updated mask $M_{i+1} = M_i + \omega_k * \dfrac{\partial L}{\partial M_i}$, and $M_i$ is a mask before updating.

S5: Repeat S3 and S4, and optimize a process until a preset number of iterative training times is reached or a gradient reaches an expected value.

Specifically, in a possible implementation, S3 and S4 are repeated, and the optimization process is repeated until a preset number of iterative training times is reached. For example, the preset number of iterative training times is 1000. When the number of iterative training times reaches 1000, the optimization process is stopped. In another possible implementation, S3 and S4 are repeated, and the optimization process is stopped until the gradient reaches an expected value. The expected value of the gradient may be preset.

S6: Perform binarization processing on the optimized mask, that is, the pixel value in the mask exceeds 0.5 to be 1, and otherwise is to be 0.

Finally, the optimized mask is the mask of the pre-defined layout. For the pre-defined layout of each chip sample, the mask of the pre-defined layout of the chip sample is obtained through the foregoing method.

The following further describes a technical effect of the method for training a mask generation model provided in the embodiments of the present disclosure through experimental data.

To verify an effect of the method for training a mask generation model and apply the method for training a mask generation model to photolithography mask design of the chip layout, a widely used public photolithography mask data set is selected in this embodiment. A total of 10271 chip layouts and corresponding masks are included in the two data sets. The chip layout is generated meeting a 32 nm process node and a specific design rule. The mask in the photolithography mask data set is obtained through the foregoing pixelation-based inverse lithography method.

The foregoing photolithography mask data set is used, the mask generation model training is performed based on the method for training a mask generation model provided in the embodiments of the present disclosure, to obtain the mask generation model.

FIG. 7 is a schematic diagram of a comparison of mask effects according to an embodiment of the present disclosure. As shown in FIG. 7, four columns in FIG. 7 sequentially represent a pre-defined layout, a mask of the pre-defined layout, a wafer pattern, and a difference between the pre-defined layout and the wafer pattern. For the same pre-defined layout (such as a first column of pre-defined layouts shown in FIG. 7). A first behavior uses a mask, a wafer pattern, and a difference between the pre-defined layout and the wafer pattern that are generated by the mask generation model obtained by the method for training a mask generation model provided in this embodiment of the present disclosure. A second behavior uses a mask, a wafer pattern, and a difference between the pre-defined layout and the wafer pattern that are generated by an existing mask optimization algorithm. A third behavior uses a mask, a wafer pattern, and a difference between a pre-defined layout and a wafer pattern that are generated by an existing inverse lithography mask optimization algorithm. After comparing the three algorithms, it can be seen that based on the method provided in this embodiment of the present disclosure, the generated mask has the least complexity, there are no micro structures such as holes, isolated items, and sawteeth, and the pre-defined layout is closest to the wafer pattern.

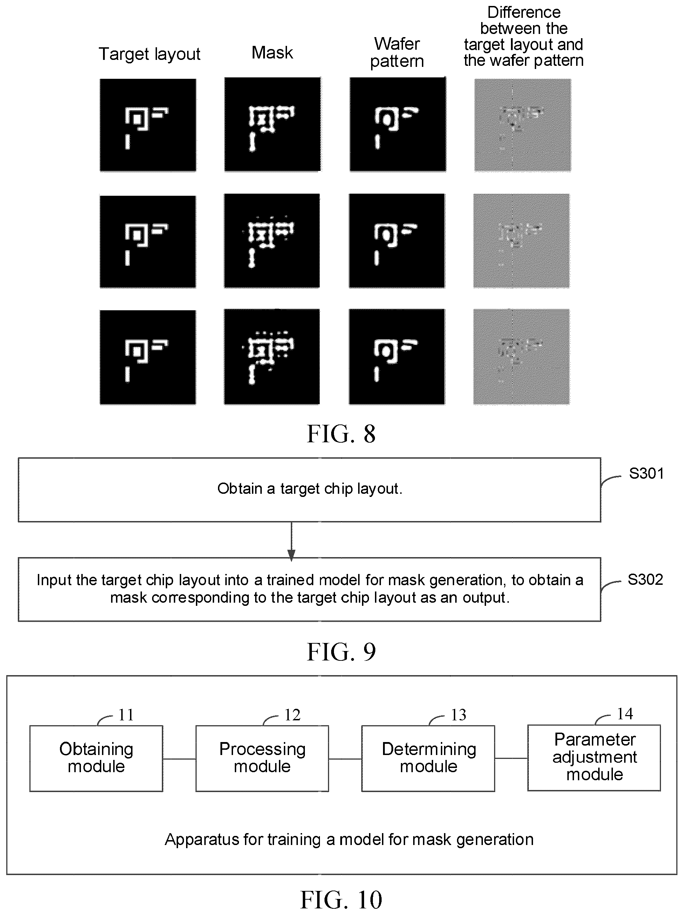

FIG. 8 is a schematic diagram of a comparison of mask effects according to an embodiment of the present disclosure. As shown in FIG. 8, four columns in FIG. 8 sequentially represent a pre-defined layout, a mask of the pre-defined layout, a wafer pattern, and a difference between the pre-defined layout and the wafer pattern. For the same pre-defined layout (such as a first column of pre-defined layouts shown in FIG. 8). A first behavior uses a mask, a wafer pattern, and a difference between the pre-defined layout and the wafer pattern that are generated by the mask generation model obtained by the method for training a mask generation model provided in this embodiment of the present disclosure. A second behavior uses a mask, a wafer pattern, and a difference between the pre-defined layout and the wafer pattern that are generated by an existing mask optimization algorithm. A third behavior uses a mask, a wafer pattern, and a difference between a pre-defined layout and a wafer pattern that are generated by an existing inverse lithography mask optimization algorithm. After comparing the three algorithms, it can be seen that based on the method provided in this embodiment of the present disclosure, the generated mask has the least complexity, there are no micro structures such as holes, isolated items, and sawteeth, and the pre-defined layout is closest to the wafer pattern. Masks generated by the other two methods are more complex, there are holes, isolated items, or the like.

In some embodiments, the mask generation model in this embodiment may include an encoder and a decoder. The encoder includes a plurality of convolutional neural network layers, and the decoder includes a plurality of deconvolutional neural network layers. In a possible implementation, the encoder includes 8 convolutional neural network layers, and the decoder includes eight deconvolutional neural network layers. Specifically, the eight convolutional layers are respectively formed by eight $3\times3$ filters, 16 $3\times3$ filters, 32 $3\times3$ filters, 64 $3\times3$ filters, 128 $3\times3$ filters, 256 $3\times3$ filters, 512 $3\times3$ filters, and 1024 $3\times3$ filters. A batch normalization layer is established after each convolutional layer and a subsequent activation function uses a modified linear unit (ReLU). After a pre-defined layout of a chip with dimensions (256, 256, 1) is inputted, a final output with dimensions (1, 1, 1024) is used as an input of the decoder. The first seven deconvolutional layers are respectively formed by 1024 $3\times3$ filters, 512 $3\times3$ filters, 256 $3\times3$ filters, 128 $3\times3$ filters, 64 $3\times3$ filters, 32 $3\times3$ filters, and 16 $3\times3$ filters sequentially. After each deconvolutional layer, a batch normalization layer is established and a Leaky modified linear unit (Leaky-ReLU) is used as a subsequent activation function. Finally, a deconvolutional neural network layer including eight $3\times3$ filters and a sigmoid activation function gives a predicted mask with dimensions (256, 256, 1) and values 0 to 1, and then binarization processing is performed on the mask to obtain a final mask.

FIG. 9 is a flowchart of a method for mask generation according to an embodiment of the present disclosure. An execution body of the method may be a server. As shown in FIG. 9, the method may include:

S301: Obtain a chip layout.

S302: Input the chip layout into a trained mask generation model, to obtain a mask corresponding to the chip layout as an output.

The mask generation model is obtained through training based on the method in the embodiment shown in FIG. 2 or FIG. 6.

Based on the method for mask generation provided in this embodiment, a mask with low complexity can be generated through the mask generation model, so that a mask with high quality can be provided for a subsequent chip photolithography process, thereby reducing calculation time and manufacturing costs of the mask.

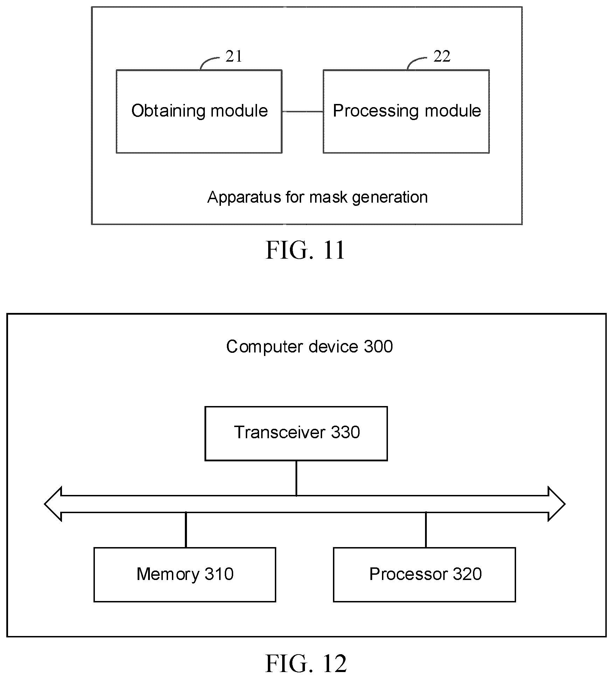

FIG. 10 is a schematic structural diagram of an apparatus for training a mask generation model according to an embodiment of the present disclosure. As shown in FIG. 11, the apparatus may include: an obtaining module 11, a processing module 12, a determining module 13, and a parameter adjustment module 14.

The obtaining module 11 is configured to obtain a set of training samples, each training sample in the set of training samples comprising a pre-defined layout of a chip sample and a mask of the pre-defined layout.

The processing module 12 is configured to use, for at least one training sample in the set of training samples, a pre-defined layout of a chip sample in the training sample as an input for a mask generation model.

The processing module 12 is further configured to obtain a predicted mask of the pre-defined layout as an output, and input the predicted mask of the pre-defined layout into a wafer pattern prediction model, which is a photolithography physical model, to obtain a wafer pattern corresponding to the predicted mask of the pre-defined layout.

The determining module 13 is configured to determine complexity of the predicted mask of the pre-defined layout based on a sum of perimeters of a plurality of graphics included in the pre-defined layout of the chip sample and a perimeter of the predicted mask of the pre-defined layout.

The parameter adjustment module 14 is configured to adjust a parameter of the mask generation model based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model.

In an embodiment, the determining module 13 is configured to: calculate contour lines of the predicted mask of the pre-defined layout based on a sum of a square of a first-order derivative of the predicted mask of the pre-defined layout in an x direction and a square of a first-order derivative of the predicted mask of the pre-defined layout in a y direction;

perform summation on the contour lines of the predicted mask of the pre-defined layout to obtain the perimeter of the predicted mask of the pre-defined layout;

obtain the sum of perimeters of the plurality of graphics L included in the pre-defined layout of the chip sample; and

obtain the complexity of the predicted mask of the pre-defined layout by calculation based on a result of dividing the perimeter of the predicted mask of the pre-defined layout by the sum of perimeters of the plurality of graphics L.

In an embodiment, the parameter adjustment module 14 is configured to:

construct a first loss function based on the pre-defined layout of the chip sample and the wafer pattern corresponding to the predicted mask of the pre-defined layout;

construct a second loss function based on the mask of the pre-defined layout and the predicted mask of the pre-defined layout;

construct a composite loss function based on the first loss function, the second loss function, and the complexity of the predicted mask of the pre-defined layout; and

adjust the parameter of the mask generation model through a gradient descent algorithm based on the composite loss function until the training stop condition is met.

In an embodiment, the parameter adjustment module 14 is further configured to:
obtain the composite loss function by calculation based on a sum of a product of a first parameter and the first loss function, a product of a second parameter and the complexity of the predicted mask of the pre-defined layout, and the second loss function.

In an embodiment, the parameter adjustment module 14 is further configured to:

obtain a gradient of the composite loss function by calculation based on the parameter of the mask generation model in a current iteration process; and

adjust the parameter of the mask generation model based on an optimization direction and an optimization step size of the gradient descent algorithm until the training stop condition is met.

In an embodiment, the mask generation model is a pre-trained model, and the obtaining module 11 is further configured to:

obtain a set of sample data, each sample data in the set of sample data including the pre-defined layout of the chip sample and the mask of the pre-defined layout; and

the processing module 12 is further configured to train a deep learning model based on the set of sample data to obtain the mask generation model.

In an embodiment, the obtaining module 11 is further configured to:

obtain the set of sample data by using a pixelation-based inverse lithography method; and

select a preset number of pieces of sample data from the set of sample data, and forming the set of training samples using the preset number of pieces of sample data.

In an embodiment, the mask generation model includes an encoder and a decoder. The encoder includes a plurality of convolutional neural network layers, and the decoder includes a plurality of deconvolutional neural network layers.
FIG. 11 is a schematic structural diagram of an apparatus for mask generation according to an embodiment of the present disclosure. As shown in FIG. 11, the apparatus may include: an obtaining module 21 and a processing module 22.
The obtaining module 21 is configured to obtain a chip layout.
The processing module 22 is configured to input the chip layout into a trained mask generation model, to obtain a mask corresponding to the chip layout as an output, the mask generation model being obtained through training according to the method in the embodiment shown in FIG. 1.
Apparatus embodiments and method embodiments may correspond to each other. For a similar description, reference may be made to the method embodiments. To avoid repetition, details are not described herein again. Specifically, the apparatus for training a mask generation model shown in FIG. 10 or the apparatus for mask generation shown in FIG. 11 may perform a method embodiment corresponding to the terminal device or the server, and the foregoing and other operations and/or functions of the modules in the apparatus are respectively intended to implement the method embodiment corresponding to the terminal device or the server. For brevity, details are not described herein again.

The apparatus for training a mask generation model and the apparatus for mask generation of the embodiments of the present disclosure are described above with reference to the accompanying drawings from a perspective of a functional module. The functional module may be implemented in hardware form, or may be implemented in software form of instructions, or may be implemented through a combination of hardware and software modules. Specifically, operations of the method embodiments in the embodiments of the present disclosure may be completed by instructions in the form of hardware integrated logic circuits and/or software in the processor, and operations of the methods disclosed with reference to the embodiments of the present disclosure may be directly performed and completed by using a hardware decoding processor, or may be performed and completed by using a combination of hardware and software modules in the decoding processor. In some embodiments, the software module may be located in a mature storage medium in the art, such as a random access memory, a flash memory, a read-only memory, a programmable read-only memory, an electrically-erasable programmable memory, and a register. The storage medium is located in the memory. The processor reads information in the memory and completes the operations of the foregoing method embodiments in combination with hardware thereof.

FIG. 12 is a schematic block diagram of a computer device 300 according to an embodiment of the present disclosure.

As shown in FIG. 12, the computer device 300 may include:

a memory 310 and a processor 320. The memory 310 is configured to store a computer program and transmit program code to the processor 320. In other words, the processor 320 may invoke and run the computer program from the memory 310 to implement the method in the embodiments of the present disclosure.

For example, the processor 320 may be configured to perform the foregoing method embodiment based on instructions in the computer program.

In some embodiments of the embodiments of the present disclosure, the processor 320 may include, but is not limited to:

a general processor, a digital signal processor (DSP), an application specific integrated circuit (ASIC), a field programmable gate array (FPGA), another programmable logic device, a discrete gate, a transistor logic device, a discrete hardware component, or the like.

In some embodiments of the embodiments of the present disclosure, the memory 310 includes, but is not limited to:

a non-volatile memory and/or a volatile memory. The non-volatile memory may be a read-only memory (ROM), a programmable read-only memory (PROM), an erasable programmable read-only memory (EPROM), an electrically erasable programmable read-only memory (EEPROM), or a flash memory. The volatile memory may be a random access memory (RAM) that is used as an external cache. Through example but not limitative description, many forms of RAMs may be used, for example, a static random access memory (SRAM), a dynamic random access memory (DRAM), a synchronous dynamic random access memory (SDRAM), a double data rate synchronous dynamic random access memory (DDR SDRAM), an enhanced synchronous dynamic random access memory (ESDRAM), a synchronous link dynamic random access memory (SLDRAM), and a direct rambus dynamic random access memory (DR RAM).

In some embodiments of the embodiments of the present disclosure, the computer program may be divided into one or more modules, and the one or more modules are stored in the memory 310 and executed by the processor 320 to perform the methods provided in the embodiments of the present disclosure. The one or more modules may be a series of computer program instruction segments capable of performing a particular function, and the instruction segments are configured for describing the execution of the computer program in the electronic device.

As shown in FIG. 12, the computer device may further include:

a transceiver 330. The transceiver 330 may be connected to the processor 320 or the memory 310.

The processor 320 may control the transceiver 330 to communicate with another device, and specifically, may send information or data to another device or receive information or data sent by another device. The transceiver 330 may include a transmitter and a receiver. The transceiver 330 may further include an antenna, and a number of antennas may be one or more.

Various components of the electronic device are connected to each other by using a bus system. In addition to including a data bus, the bus system further includes a power bus, a control bus, and a status signal bus.

An embodiment of the present disclosure further provides a computer storage medium, having a computer program stored therein. When the computer program is executed by a computer, the computer is enabled to perform the method according to the foregoing method embodiments. In other words, an embodiment of the present disclosure further provides a computer program product including instructions. When the instructions executed by a computer, the computer is caused to perform the method according to the foregoing method embodiments.

When software is used to implement embodiments, all or a part of the embodiments may be implemented in a form of a computer program product. The computer program product includes one or more computer instructions. When the program instruction of the computer is loaded and executed on the computer program, all or some of the steps are generated according to the process or function described in the embodiments of the present disclosure. The computer may be a general-purpose computer, a special-purpose computer, a computer network, or another programmable apparatus. The computer instructions may be stored in a computer-readable storage medium or transmitted from one computer-readable storage medium to another computer-readable storage medium. For example, the computer instructions may be transmitted from one website, computer, server or data center to another website, computer, server or data center in a wired (for example, a coaxial cable, an optical fiber or a digital subscriber line (DSL)) or wireless (for example, infrared, wireless or microwave) manner. The computer-readable storage medium may be any usable medium accessible by the computer, or a data storage device, for example, a server or a data center, integrating one or more usable media. The available medium may be a magnetic medium (such as a floppy disk, a hard disk, or a magnetic tape), an optical medium (such as a digital video disc (DVD)), a semiconductor medium (such as a solid state disk (SSD)) or the like.

A person of ordinary skill in the art may be aware that, in combination with the examples described in the embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it is not to be considered that the implementation goes beyond the scope of the embodiments of the present disclosure.

In the several embodiments provided in the embodiments of the present disclosure, the disclosed system, apparatus, and method may be implemented in other manners. For example, the described apparatus embodiment is merely exemplary. For example, the module division is merely logical function division and may be other division in actual implementation. For example, a plurality of modules or components may be combined or integrated into another system, or some features may be ignored or not performed. In addition, the displayed or discussed mutual couplings or direct couplings or communication connections may be implemented by using some interfaces. The indirect couplings or communication connections between the apparatuses or modules may be implemented in electronic, mechanical, or other forms.

The modules described as separate parts may or may not be physically separate, and parts displayed as modules may or may not be physical modules, may be located in one position, or may be distributed on a plurality of network units. Some or all of the modules may be selected according to actual requirements to implement the objectives of the solutions of the embodiments. For example, functional modules in the embodiments of the present disclosure may be integrated into one processing module, or each of the modules may exist alone physically, or two or more modules may be integrated into one module.

The foregoing descriptions are merely specific implementations of the embodiments of the present disclosure, but are not intended to limit the protection scope of the embodiments of the present disclosure. Therefore, the protection scope of the embodiments of the present disclosure shall be subject to the protection scope of the claims.

**Claims**

1. A computer implemented method for training a mask generation model, comprising:

   obtaining a set of training samples, each comprising a pre-defined layout of a chip sample and a mask of the pre-defined layout (S101);
   using, for at least one of the training samples, the corresponding pre-defined layout as an input to a mask generation model, to obtain a predicted mask of the pre-defined layout as an output (S102);
   inputting the predicted mask of the pre-defined layout into a wafer pattern prediction model, which is a photolithography physical model, to obtain a wafer pattern corresponding to the predicted mask of the pre-defined layout (S103);
   determining complexity of the predicted mask of the pre-defined layout based on a sum of perimeters of a plurality of graphics comprised in the pre-defined layout of the chip sample and a perimeter of the predicted mask of the pre-defined layout (S104); and
   adjusting a parameter of the mask generation model based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model (S105).

2. The method according to claim 1, wherein the determining complexity of the predicted mask of the pre-defined layout based on a sum of perimeters of a plurality of graphics comprised in the pre-defined layout of the chip sample and a perimeter of the predicted mask of the pre-defined layout (S104) comprises:

calculating contour lines of the predicted mask of the pre-defined layout based on a sum of a square of a first-order derivative of the predicted mask of the pre-defined layout in an x direction and a square of a first-order derivative of the predicted mask of the pre-defined layout in a y direction (S1041);

performing summation on the contour lines of the predicted mask of the pre-defined layout to obtain the perimeter of the predicted mask of the pre-defined layout (S1042);

obtaining the sum of perimeters of the plurality of graphics L comprised in the pre-defined layout of the chip sample (S1 043); and

obtaining the complexity of the predicted mask of the pre-defined layout by calculation based on a result of dividing the perimeter of the predicted mask of the pre-defined layout by the sum of perimeters of the plurality of graphics L (S1044).

3. The method according to claim 1 or 2, wherein the adjusting a parameter of the mask generation model based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model (S105) comprises:

constructing a first loss function based on the pre-defined layout of the chip sample and the wafer pattern corresponding to the predicted mask of the pre-defined layout (S1051);

constructing a second loss function based on the mask of the pre-defined layout and the predicted mask of the pre-defined layout (S1052);

constructing a composite loss function based on the first loss function, the second loss function, and the complexity of the predicted mask of the pre-defined layout (S1053); and

adjusting the parameter of the mask generation model through a gradient descent algorithm based on the composite loss function until the training stop condition is met (S1054).

4. The method according to claim 3, wherein the constructing a composite loss function based on the first loss function, the second loss function, and the complexity of the predicted mask of the pre-defined layout (S1053) comprises:
obtaining the composite loss function by calculation based on a sum of a product of a first parameter and the first loss function, a product of a second parameter and the complexity of the predicted mask of the pre-defined layout, and the second loss function.

5. The method according to claim 3, wherein the adjusting the parameter of the mask generation model through a gradient descent algorithm based on the composite loss function until the training stop condition is met (S1054) comprises:

obtaining a gradient of the composite loss function by calculation based on the parameter of the mask generation model in a current iteration process; and

adjusting the parameter of the mask generation model based on an optimization direction and an optimization step size of the gradient descent algorithm until the training stop condition is met.

6. The method according to any one of claims 1 to 5, wherein the mask generation model is a pre-trained model, and the method further comprises:

obtaining a set of sample data, each sample data in the set of sample data comprising the pre-defined layout of the chip sample and the mask of the pre-defined layout (S201); and

Pre-training a deep learning model based on the set of sample data to obtain the mask generation model (S202).

7. The method according to claim 6, wherein the obtaining a set of sample data comprises:

obtaining the set of sample data by using a pixelation-based inverse lithography method; and

the obtaining a set of training samples comprises:

selecting a preset number of pieces of sample data from the set of sample data, and forming the set of training samples using the preset number of pieces of sample data.

8. The method according to any one of claims 1 to 7, wherein the mask generation model comprises an encoder and a decoder, the encoder comprises a plurality of convolutional neural network layers, and the decoder comprises a plurality of deconvolutional neural network layers.

9. A method for mask generation, comprising:

obtaining a chip layout; and

inputting the chip layout into a trained mask generation model to obtain a mask corresponding to the chip layout as an output, the mask generation model being obtained through training according to the method according to any one of claims 1 to 8.

10. An apparatus for training a mask generation model, comprising:

an obtaining module (11), configured to obtain a set of training samples, each training sample in the set of training samples comprising a pre-defined layout of a chip sample and a mask of the pre-defined layout;

a processing module (12), configured to use, for at least one training sample in the set of training samples, a pre-defined layout of a chip sample in the training sample as an input for a mask generation model (10), to obtain a predicted mask of the pre-defined layout as an output,

the processing module being further configured to input the predicted mask of the pre-defined layout into a wafer pattern prediction model, which is a photolithography physical model, to obtain a wafer pattern corresponding to the predicted mask of the pre-defined layout;

a determining module (13), configured to determine complexity of the predicted mask of the pre-defined layout based on a sum of perimeters of a plurality of graphics comprised in the pre-defined layout of the chip sample and a perimeter of the predicted mask of the pre-defined layout; and

a parameter adjustment module (14), configured to adjust a parameter of the mask generation model (10) based on the pre-defined layout of the chip sample, the wafer pattern corresponding to the predicted mask of the pre-defined layout, the mask of the pre-defined layout, the predicted mask of the pre-defined layout, and the complexity of the predicted mask of the pre-defined layout until a training stop condition is met, to obtain a trained mask generation model (10).

11. An apparatus for mask generation, comprising:

an obtaining module (21), configured to obtain a chip layout; and

a processing module (22), configured to input the chip layout into a trained mask generation model (10) to obtain a mask corresponding to the chip layout as an output, the mask generation model (10) being obtained through training according to the method according to any one of claims 1 to 8.

12. A computer device (300), comprising:
a processor (320) and a memory (310), the memory (310) being configured to store a computer program, and the processor (320) being configured to invoke and run the computer program stored in the memory (310), to perform the method according to any one of claims 1 to 8 or 9.

13. A computer-readable storage medium, comprising instructions, the instructions, when run on a computer, causing the computer to perform the method according to any one of claims 1 to 8 or 9.

14. A computer program product comprising instructions, the instructions, when run on a computer, causing the computer to perform the method according to any one of claims 1 to 8 or claim 9.

**Patentansprüche**

1. Ein computerimplementiertes Verfahren zum Trainieren eines Maskenerzeugungsmodells, umfassend:

Erhalten einer Menge von Trainingsmustern, wobei jedes ein vordefiniertes Layout eines Chipmusters und eine Maske des vordefinierten Layouts umfasst (S101);

Verwenden, für zumindest eines der Trainingsmuster, des entsprechenden vordefinierten Layouts als Eingabe für ein Maskenerzeugungsmodell, um eine vorhergesagte Maske des vordefinierten Layouts als Ausgabe zu erhalten (S102);

Eingeben der vorhergesagten Maske des vordefinierten Layouts in ein Waferstrukturvorhersagemodell, welches ein photolithographisches physikalisches Modell ist, um eine Waferstruktur zu erhalten, die der vorhergesagten Maske des vordefinierten Layouts entspricht (S103);

Bestimmen einer Komplexität der vorhergesagten Maske des vordefinierten Layouts basierend auf einer Summe von Umfängen einer Vielzahl von Grafiken, die in dem vordefinierten Layout des Chipmusters enthalten sind, und einem Umfang der vorhergesagten Maske des vordefinierten Layouts (S104); und

Anpassen eines Parameters des Maskenerzeugungsmodells basierend auf dem vordefinierten Layout des Chipmusters, der Waferstruktur, die der vorhergesagten Maske des vordefinierten Layouts entspricht, der Maske des vordefinierten Layouts, der vorhergesagten Maske des vordefinierten Layouts und der Komplexität der vorhergesagten Maske des vordefinierten Layouts, bis eine Trainingsstoppbedingung erfüllt ist, um ein trainiertes Maskenerzeugungsmodell zu erhalten (S105).

2. Das Verfahren nach Anspruch 1, wobei das Bestimmen der Komplexität der vorhergesagten Maske des vordefinierten Layouts basierend auf einer Summe von Umfängen einer Vielzahl von Grafiken, die in dem vordefinierten Layout des Chipmusters enthalten sind, und einem Umfang der vorhergesagten Maske des vordefinierten Layouts (S104) umfasst:

Berechnen von Konturlinien der vorhergesagten Maske des vordefinierten Layouts basierend auf einer Summe eines Quadrats einer ersten Ableitung erster Ordnung der vorhergesagten Maske des vordefinierten Layouts in einer x-Richtung und eines Quadrats einer ersten Ableitung erster Ordnung der vorhergesagten Maske des vordefinierten Layouts in einer y-Richtung (S1041);
Durchführen einer Summation der Konturlinien der vorhergesagten Maske des vordefinierten Layouts, um den Umfang der vorhergesagten Maske des vordefinierten Layouts zu erhalten (S1042);
Erhalten der Summe von Umfängen der Vielzahl von Grafiken L, die in dem vordefinierten Layout des Chipmusters enthalten sind (S1043); und
Erhalten der Komplexität der vorhergesagten Maske des vordefinierten Layouts durch Berechnung basierend auf einem Ergebnis der Division des Umfangs der vorhergesagten Maske des vordefinierten Layouts durch die Summe von Umfängen der Vielzahl von Grafiken L (S1044).

3. Das Verfahren nach Anspruch 1 oder 2, wobei das Anpassen eines Parameters des Maskenerzeugungsmodells basierend auf dem vordefinierten Layout des Chipmusters, der Waferstruktur, die der vorhergesagten Maske des vordefinierten Layouts entspricht, der Maske des vordefinierten Layouts, der vorhergesagten Maske des vordefinierten Layouts und der Komplexität der vorhergesagten Maske des vordefinierten Layouts, bis die Trainingsstoppbedingung erfüllt ist, um ein trainiertes Maskenerzeugungsmodell zu erhalten (S105), umfasst:

Konstruieren einer ersten Verlustfunktion basierend auf dem vordefinierten Layout des Chipmusters und der Waferstruktur, die der vorhergesagten Maske des vordefinierten Layouts entspricht (S1051);
Konstruieren einer zweiten Verlustfunktion basierend auf der Maske des vordefinierten Layouts und der vorhergesagten Maske des vordefinierten Layouts (S1052);
Konstruieren einer zusammengesetzten Verlustfunktion basierend auf der ersten Verlustfunktion, der zweiten Verlustfunktion und der Komplexität der vorhergesagten Maske des vordefinierten Layouts (S1053); und
Anpassen des Parameters des Maskenerzeugungsmodells mittels eines Gradientenabstiegsalgorithmus basierend auf der zusammengesetzten Verlustfunktion, bis die Trainingsstoppbedingung erfüllt ist (S1054).

4. Das Verfahren nach Anspruch 3, wobei das Konstruieren einer zusammengesetzten Verlustfunktion basierend auf der ersten Verlustfunktion, der zweiten Verlustfunktion und der Komplexität der vorhergesagten Maske des vordefinierten Layouts (S1053) umfasst:
Erhalten der zusammengesetzten Verlustfunktion durch Berechnung basierend auf einer Summe eines Produkts eines ersten Parameters und der ersten Verlustfunktion, eines Produkts eines zweiten Parameters und der Komplexität der vorhergesagten Maske des vordefinierten Layouts sowie der zweiten Verlustfunktion.

5. Das Verfahren nach Anspruch 3, wobei das Anpassen des Parameters des Maskenerzeugungsmodells mittels eines Gradientenabstiegsalgorithmus basierend auf der zusammengesetzten Verlustfunktion, bis die Trainingsstoppbedingung erfüllt ist (S1054), umfasst:

Erhalten eines Gradienten der zusammengesetzten Verlustfunktion durch Berechnung basierend auf dem Parameter des Maskenerzeugungsmodells in einem aktuellen Iterationsprozess; und
Anpassen des Parameters des Maskenerzeugungsmodells basierend auf einer Optimierungsrichtung und einer Optimierungsschrittweite des Gradientenabstiegsalgorithmus, bis die Trainingsstoppbedingung erfüllt ist.

6. Das Verfahren nach einem der Ansprüche 1 bis 5, wobei das Maskenerzeugungsmodell ein vortrainiertes Modell ist, und wobei das Verfahren ferner umfasst:

Erhalten einer Menge von Beispieldaten, wobei jedes Beispieldatum in der Menge von Beispieldaten das vordefinierte Layout des Chipmusters und die Maske des vordefinierten Layouts umfasst (S201); und Vortrainieren eines Deep-Learning-Modells basierend auf der Menge von Beispieldaten, um das Maskenerzeugungsmodell zu erhalten (S202).

7. Das Verfahren nach Anspruch 6, wobei das Erhalten einer Menge von Beispieldaten umfasst:

Erhalten der Menge von Beispieldaten unter Verwendung eines auf Pixelierung basierenden inversen Lithographieverfahrens; und
wobei das Erhalten einer Menge von Trainingsmustern Folgendes umfasst:
Auswählen einer voreingestellten Anzahl von Stücken von Beispieldaten aus der Menge von Beispieldaten und Bilden der Menge von Trainingsmustern unter Verwendung der voreingestellten Anzahl von Stücken von Beispieldaten.

8. Das Verfahren nach einem der Ansprüche 1 bis 7, wobei das Maskenerzeugungsmodell einen Encoder und einen Decoder umfasst, der Encoder eine Vielzahl von Faltungsneuronennetzwerk-Schichten umfasst und der Decoder eine Vielzahl von Defaltungsneuronennetzwerk-Schichten umfasst.

9. Ein Verfahren zur Maskenerzeugung, umfassend:

Erhalten eines Chip-Layouts; und
Eingeben des Chip-Layouts in ein trainiertes Maskenerzeugungsmodell, um eine Maske zu erhalten, die dem Chip-Layout entspricht, als Ausgabe, wobei das Maskenerzeugungsmodell durch Trainieren gemäß dem Verfahren nach einem der Ansprüche 1 bis 8 erhalten wird.

10. Eine Vorrichtung zum Trainieren eines Maskenerzeugungsmodells, umfassend:

ein Erhaltemodul (11), eingerichtet zum Erhalten einer Menge von Trainingsmustern, wobei jedes Trainingsmuster in der Menge von Trainingsmustern ein vordefiniertes Layout eines Chipmusters und eine Maske des vordefinierten Layouts umfasst;
ein Verarbeitungsmodul (12), eingerichtet zum Verwenden, für zumindest ein Trainingsmuster in der Menge von Trainingsmustern, eines vordefinierten Layouts eines Chipmusters in dem Trainingsmuster als Eingabe für ein Maskenerzeugungsmodell (10), um eine vorhergesagte Maske des vordefinierten Layouts als Ausgabe zu erhalten,
wobei das Verarbeitungsmodul ferner eingerichtet ist, die vorhergesagte Maske des vordefinierten Layouts in ein Waferstrukturvorhersagemodell einzugeben, welches ein photolithographisches physikalisches Modell ist, um eine Waferstruktur zu erhalten, die der vorhergesagten Maske des vordefinierten Layouts entspricht;
ein Bestimmungsmodul (13), eingerichtet zum Bestimmen einer Komplexität der vorhergesagten Maske des vordefinierten Layouts basierend auf einer Summe von Umfängen einer Vielzahl von Grafiken, die in dem vordefinierten Layout des Chipmusters enthalten sind, und einem Umfang der vorhergesagten Maske des vordefinierten Layouts; und
ein Parameteranpassungsmodul (14), eingerichtet zum Anpassen eines Parameters des Maskenerzeugungsmodells (10) basierend auf dem vordefinierten Layout des Chipmusters, der Waferstruktur, die der vorhergesagten Maske des vordefinierten Layouts entspricht, der Maske des vordefinierten Layouts, der vorhergesagten Maske des vordefinierten Layouts und der Komplexität der vorhergesagten Maske des vordefinierten Layouts, bis eine Trainingsstoppbedingung erfüllt ist, um ein trainiertes Maskenerzeugungsmodell (10) zu erhalten.

11. Eine Vorrichtung zur Maskenerzeugung, umfassend:

ein Erhaltemodul (21), eingerichtet zum Erhalten eines Chip-Layouts; und
ein Verarbeitungsmodul (22), eingerichtet zum Eingeben des Chip-Layouts in ein trainiertes Maskenerzeugungsmodell (10), um eine Maske zu erhalten, die dem Chip-Layout entspricht, als Ausgabe, wobei das Maskenerzeugungsmodell (10) durch Trainieren gemäß dem Verfahren nach einem der Ansprüche 1 bis 8 erhalten wird.

12. Eine Recheneinrichtung (300), umfassend:
einen Prozessor (320) und einen Speicher (310), wobei der Speicher (310) eingerichtet ist zum Speichern eines Computerprogramms und wobei der Prozessor (320) eingerichtet ist zum Aufrufen und Ausführen des im Speicher (310) gespeicherten Computerprogramms, um das Verfahren nach einem der Ansprüche 1 bis 8 oder 9 auszuführen.

**13.** Ein computerlesbares Speichermedium, umfassend Anweisungen, wobei die Anweisungen, wenn sie auf einem Computer ausgeführt werden, den Computer veranlassen, das Verfahren nach einem der Ansprüche 1 bis 8 oder 9 auszuführen.

**14.** Ein Computerprogrammprodukt, umfassend Anweisungen, wobei die Anweisungen, wenn sie auf einem Computer ausgeführt werden, den Computer veranlassen, das Verfahren nach einem der Ansprüche 1 bis 8 oder Anspruch 9 auszuführen.

**Revendications**

**1.** Procédé mis en œuvre par ordinateur permettant d'entraîner un modèle de génération de masque, comprenant:

l'obtention d'un ensemble d'échantillons d'entraînement, chacun comprenant une disposition prédéfinie d'un échantillon de puce et un masque de la disposition prédéfinie (S101);

l'utilisation, pour au moins un des échantillons d'entraînement, de la disposition prédéfinie correspondante comme entrée d'un modèle de génération de masque, afin d'obtenir un masque prédit de la disposition prédéfinie comme sortie (S102);

l'entrée du masque prédit de la disposition prédéfinie dans un modèle de prédiction de motif de plaquette, qui est un modèle physique photolithographique, afin d'obtenir un motif de plaquette correspondant au masque prédit de la disposition prédéfinie (S103);

la détermination de la complexité du masque prédit de la disposition prédéfinie sur la base d'une somme des périmètres d'une pluralité de graphiques compris dans la disposition prédéfinie de l'échantillon de puce et d'un périmètre du masque prédit de la disposition prédéfinie (S104); et

l'ajustement d'un paramètre du modèle de génération de masque sur la base de la disposition prédéfinie de l'échantillon de puce, du motif de plaquette correspondant au masque prédit de la disposition prédéfinie, du masque de la disposition prédéfinie, du masque prédit de la disposition prédéfinie et de la complexité du masque prédit de la disposition prédéfinie jusqu'à ce qu'une condition d'arrêt d'entraînement soit remplie, afin d'obtenir un modèle de génération de masque entraîné (S105).

**2.** Procédé selon la revendication 1, dans lequel la détermination de la complexité du masque prédit de la disposition prédéfinie sur la base d'une somme des périmètres d'une pluralité de graphiques compris dans la disposition prédéfinie de l'échantillon de puce et d'un périmètre du masque prédit de la disposition prédéfinie (S104) consiste à:

calculer les lignes de contour du masque prédit de la disposition prédéfinie sur la base d'une somme d'un carré d'une dérivée de premier ordre du masque prédit de la disposition prédéfinie dans une direction x et d'un carré d'une dérivée de premier ordre du masque prédit de la disposition prédéfinie dans une direction y (S1041);

effectuer une sommation sur les lignes de contour du masque prédit de la disposition prédéfinie afin d'obtenir le périmètre du masque prédit de la disposition prédéfinie (S1042);

obtenir la somme des périmètres de la pluralité de graphiques L compris dans la disposition prédéfinie de l'échantillon de puce (S1043); et

obtenir la complexité du masque prédit de la disposition prédéfinie par calcul basé sur un résultat de division du périmètre du masque prédit de la disposition prédéfinie par la somme des périmètres de la pluralité de graphiques L (S1044).

**3.** Procédé selon la revendication 1 ou 2, dans lequel l'ajustement d'un paramètre du modèle de génération de masque sur la base de la disposition prédéfinie de l'échantillon de puce, du motif de plaquette correspondant au masque prédit de la disposition prédéfinie, du masque de la disposition prédéfinie, du masque prédit de la disposition prédéfinie et de la complexité du masque prédit de la disposition prédéfinie jusqu'à ce qu'une condition d'arrêt d'apprentissage soit remplie, afin d'obtenir un modèle de génération de masque appris (S105) consistant à:

construire une première fonction de perte basée sur la disposition prédéfinie de l'échantillon de puce et le motif de plaquette correspondant au masque prédit de la disposition prédéfinie (S1051);

construire une deuxième fonction de perte basée sur le masque de la disposition prédéfinie et le masque prédit de la disposition prédéfinie (S1052) ;

construire une fonction de perte composite basée sur la première fonction de perte, la deuxième fonction de perte et la complexité du masque prédit de la disposition prédéfinie (S1053); et

ajuster le paramètre du modèle de génération de masque à l'aide d'un algorithme de descente de gradient basé sur la fonction de perte composite jusqu'à ce que la condition d'arrêt de l'apprentissage soit remplie (S1054).

4.  Procédé selon la revendication 3, dans lequel la construction d'une fonction de perte composite basée sur la première fonction de perte, la deuxième fonction de perte et la complexité du masque prédit de la disposition prédéfinie (S1053) consiste à :
    obtenir la fonction de perte composite par calcul basé sur une somme d'un produit d'un premier paramètre et de la première fonction de perte, d'un produit d'un deuxième paramètre et de la complexité du masque prédit de la disposition prédéfinie, et de la deuxième fonction de perte.

5.  Procédé selon la revendication 3, dans lequel l'ajustement du paramètre du modèle de génération de masque à l'aide d'un algorithme de descente de gradient basé sur la fonction de perte composite jusqu'à ce que la condition d'arrêt de l'apprentissage soit remplie (S1054) consiste à :

    obtenir un gradient de la fonction de perte composite par calcul basé sur le paramètre du modèle de génération de masque dans un processus d'itération actuel ; et
    ajuster le paramètre du modèle de génération de masque en fonction d'une direction d'optimisation et d'une taille de pas d'optimisation de l'algorithme de descente de gradient jusqu'à ce que la condition d'arrêt de l'apprentissage soit remplie.

6.  Procédé selon l'une quelconque des revendications 1 à 5, dans lequel le modèle de génération de masque est un modèle pré-entraîné, et le procédé comprend en outre :

    l'obtention d'un ensemble de données d'échantillons, chaque donnée d'échantillon dans l'ensemble de données d'échantillons comprenant la disposition prédéfinie de l'échantillon de puce et le masque de la disposition prédéfinie (S201) ; et
    l'entraînement préalable d'un modèle d'apprentissage profond basé sur l'ensemble des données échantillons afin d'obtenir le modèle de génération de masque (S202).

7.  Procédé selon la revendication 6, dans laquelle l'obtention d'un ensemble de données d'échantillons comprend :

    l'obtention de l'ensemble de données d'échantillons en utilisant une méthode de lithographie inverse basée sur la pixellisation ; et
    l'obtention d'un ensemble d'échantillons d'apprentissage consistant à :
    sélectionner un nombre prédéfini d'éléments de données d'échantillon à partir de l'ensemble de données d'échantillon, et former l'ensemble d'échantillons d'entraînement à l'aide du nombre prédéfini d'éléments de données d'échantillon.

8.  Procédé selon l'une quelconque des revendications 1 à 7, dans lequel le modèle de génération de masque comprend un codeur et un décodeur, le codeur comprend une pluralité de couches de réseau neuronal convolutif, et le décodeur comprend une pluralité de couches de réseau neuronal de déconvolution.

9.  Procédé de génération de masque, comprenant :

    l'obtention d'une disposition de puce ; et
    l'entrée de la disposition de la puce dans un modèle de génération de masque entraîné afin d'obtenir en sortie un masque correspondant à la disposition de la puce, le modèle de génération de masque étant obtenu par entraînement selon le procédé décrit dans l'une quelconque des revendications 1 à 8.

10. Appareil d'entraînement d'un modèle de génération de masque, comprenant :

    un module d'obtention (11) configuré pour obtenir un ensemble d'échantillons d'entraînement, chacun comprenant une disposition prédéfinie d'un échantillon de puce et un masque de la disposition prédéfinie ;
    un module de traitement (12), configuré pour utiliser, pour au moins un échantillon d'entraînement dans l'ensemble d'échantillons d'entraînement, une disposition prédéfinie d'un échantillon de puce dans l'échantillon d'entraînement comme entrée pour un modèle de génération de masque (10), pour obtenir en sortie un masque prédit de la disposition prédéfinie,
    le module de traitement étant en outre configuré pour entrer le masque prédit de la disposition prédéfinie dans un modèle de prédiction de motif de plaquette, qui est un modèle physique photolithographique, afin d'obtenir un motif de plaquette correspondant au masque prédit de la disposition prédéfinie;
un module de détermination (13) configuré pour déterminer la complexité du masque prédit de la disposition prédéfinie sur la base d'une somme des périmètres d'une pluralité de graphiques compris dans la disposition prédéfinie de l'échantillon de puce et d'un périmètre du masque prédit de la disposition prédéfinie; et
un module d'ajustement de paramètre (14) configuré pour ajuster un paramètre du modèle de génération de masque (10) sur la base de la disposition prédéfinie de l'échantillon de puce, du motif de plaquette correspondant au masque prédit de la disposition prédéfinie, du masque de la disposition prédéfinie, du masque prédit de la disposition prédéfinie et de la complexité du masque prédit de la disposition prédéfinie jusqu'à ce qu'une condition d'arrêt d'entraînement soit remplie, afin d'obtenir un modèle de génération de masque entraîné (10).

11. Appareil de génération de masque, comprenant:

un module d'obtention (21), configuré pour obtenir une disposition de puce; et
un module de traitement (22), configuré pour entrer la disposition de la puce dans un modèle de génération de masque entraîné (10) afin d'obtenir en sortie un masque correspondant à la disposition de la puce, le modèle de génération de masque (10) étant obtenu par entraînement selon le procédé selon l'une quelconque des revendications 1 à 8.

12. Dispositif informatique (300), comprenant:
un processeur (320) et une mémoire (310), la mémoire (310) étant configurée pour stocker un programme informatique, et le processeur (320) étant configuré pour appeler et faire fonctionner le programme informatique stocké dans la mémoire (310), pour exécuter le procédé selon l'une quelconque des revendications 1 à 8 ou 9.

13. Support d'enregistrement lisible par ordinateur, comprenant des instructions, les instructions, lorsqu'elles sont exécutées sur un ordinateur, amenant l'ordinateur à exécuter le procédé selon l'une des revendications 1 à 8 ou 9.

14. Produit programme informatique, comprenant des instructions, les instructions, lorsqu'elles sont exécutées sur un ordinateur, amenant l'ordinateur à exécuter le procédé selon l'une quelconque des revendications 1 à 8 ou la revendication 9.

FIG. 1

| Obtain a set of training samples, each training sample in the set of training samples comprising a target layout of a chip sample and a mask of the target layout. | S101 |

| For at least one training sample in the set of training samples, use a target layout of a chip sample in the training sample as an input for a model for mask generation, to obtain a predicted mask of the target layout as an output. | S102 |

| Input the predicted mask of the target layout into a photolithography physical model, to obtain a wafer pattern corresponding to the predicted mask of the target layout. | S103 |

| Determine complexity of the predicted mask of the target layout based on a sum of perimeters of a plurality of graphics included in the target layout of the chip sample and a perimeter of the predicted mask of the target layout. | S104 |

| Adjust a parameter of the model for mask generation based on the target layout of the chip sample, the wafer pattern corresponding to the predicted mask of the target layout, the mask of the target layout, the predicted mask of the target layout, and the complexity of the predicted mask of the target layout until a training stop condition is met, to obtain a trained model for mask generation. | S105 |

FIG. 2

Target layout of a chip sample

Model for mask generation 10

Predicted mask of the target layout

Photolithography physical model 20

Wafer pattern corresponding to the predicted mask

FIG. 3

Target layout of a chip sample

Predicted mask of the target layout

Contour line of the predicted mask of the target layout

30

40

FIG. 4

FIG. 5

Obtain a set of sample data, each sample data including a target layout of a chip sample and a mask of the target layout of the chip sample. — S201

Pre-train a model for mask generation based on the set of sample data. — S202

Obtain a set of training samples, each training sample in the set of training samples including a target layout of a chip sample and a mask of the target layout of the chip sample. — S203

For at least one training sample in the set of training samples, use a target layout of a chip sample in the training sample as an input of the model for mask generation, to output a predicted mask of the target layout, and input the predicted mask of the target layout into a photolithography physical model, to output a wafer pattern corresponding to the predicted mask of the target layout. — S204

Determine complexity of the predicted mask of the target layout based on a sum of perimeters of a plurality of graphics included in the target layout of the chip sample and a perimeter of the predicted mask of the target layout. — S205

Adjust a parameter of the model for mask generation based on the target layout of the chip sample, the wafer pattern corresponding to the predicted mask of the target layout, the mask of the target layout, the predicted mask of the target layout, and the complexity of the predicted mask of the target layout until a training stop condition is met, to obtain a trained model for mask generation. — S206

FIG. 6

| Target layout | Mask | Wafer pattern | Difference between the target layout and the wafer pattern |

FIG. 7

Target layout     Mask     Wafer pattern     Difference between the target layout and the wafer pattern

## FIG. 8

| | |
|---|---|
| Obtain a target chip layout. | S301 |

| | |
|---|---|
| Input the target chip layout into a trained model for mask generation, to obtain a mask corresponding to the target chip layout as an output. | S302 |

## FIG. 9

| 11 | 12 | 13 | 14 |
|---|---|---|---|
| Obtaining module | Processing module | Determining module | Parameter adjustment module |

Apparatus for training a model for mask generation

## FIG. 10

21

22

| Obtaining module | — | Processing module |

Apparatus for mask generation

FIG. 11

Computer device 300

Transceiver 330

| Memory 310 | | Processor 320 |

FIG. 12

**REFERENCES CITED IN THE DESCRIPTION**

**Patent documents cited in the description**

• CN 116342983

• CN 115222829